# EUROPEAN PATENT SPECIFICATION

(11) **EP 4 215 551 B1**
(45) Date of publication and mention of the grant of the patent: **25.11.2026**
(21) Application number: 21868991.7
(22) Date of filing: 07.07.2021
(51) Int. Cl.: C08F 2/44, C08F 290/06, H05K 3/28, C08F 222/10, G03F 7/00, C09D 11/101, C09D 11/38, C08F 2/50

(54) **CURABLE COMPOSITION, INK FOR SOLDER RESIST, AND PRINTED CIRCUIT BOARD**
HÄRTBARE ZUSAMMENSETZUNG, TINTE FÜR LÖTRESIST UND LEITERPLATTE
COMPOSITION DURCISSABLE, ENCRE POUR RÉSERVE DE SOUDURE ET CARTE DE CIRCUIT IMPRIMÉ

(30) Priority: 18.09.2020 JP 2020156822
(43) Date of publication of application: 26.07.2023
(73) Proprietor: KONICA MINOLTA, INC., Tokyo 100-7015 (JP)
(72) Inventor: NAKAHARA, Issei, Tokyo 100-7015 (JP); KATSUDA, Ai, Tokyo 100-7015 (JP); TAKABAYASHI, Toshiyuki, Tokyo 100-7015 (JP)
(74) Representative: Hoffmann Eitle
(86) International application number: PCT/JP2021/025642
(87) International publication number: WO 2022/059304

(56) References cited:
- EP-A1- 3 995 547
- EP-A1- 4 023 441
- WO-A1-00/68740
- WO-A1-02/096969
- WO-A1-2019/021639
- JP-A- 2004 004 263
- JP-A- 2014 237 814
- JP-A- 2016 069 571
- JP-A- 2016 069 571
- JP-A- 2017 179 130
- JP-A- 2019 178 270
- JP-A- 2019 178 270
- JP-A- H07 165 847

## Description

### Technical Field

The present invention relates to a curable composition, a solder resist ink, and a printed circuit board. More particularly, the present invention relates to a curable composition that provide a cured product with excellent adhesiveness and heat resistance and low relative permittivity, a solder resist ink, and a printed circuit board using this composition.

### Background Art

Materials used in mobile communication devices are sometimes required to have a dielectric constant at a specific frequency. For example, in organic EL elements used in mobile displays, it has been proposed to use a material with a specified dielectric constant at 100 kHz in order to suppress malfunction of touch sensors (Patent Document 1). In addition, in high-frequency circuits used in mobile communication devices, transmission loss occurs in the wiring part and the insulating material part, in particular, transmission loss in insulating materials has become a problem. These lead to problems of heat generation, noise, and power consumption during signal transmission. It has been shown that the transmission loss is proportional to the frequency and the dielectric loss tangent of the material, and with the introduction of the 5th generation mobile communication system (5G), the demand for materials with a low dielectric loss tangent is increasing.

On the other hand, from the viewpoint of heat resistance and electrical insulation, resin compositions that are composed mainly of curable resins such as carboxy group-containing resins and epoxy resins and also contain additive components such as fillers are widely used for use as interlayer insulation materials and solder resist materials. However, the cured products of these resin compositions contain many polar groups, resulting in materials with high dielectric constant and dielectric loss, both of which require improvement. Some photosensitive solder resist materials are mainly epoxy acrylate resins. These are mostly negative photoresists that may be developed in alkaline solutions such as sodium carbonate solution. A photosensitive solder resist is cured and stabilized by heat treatment of patterned photosensitive solder resist. Especially for epoxy acrylate resins, it is known that residual carboxylic acids are sealed with epoxy groups by this heat treatment, but even after sealing, carboxylic acids remain (Patent Document 2).

In recent years, the inkjet method has been studied in the step of forming a solder resist film, and when this technique is used, a pattern of an insulating layer corresponding to wirings may be directly formed, so that a developing step is not required, and therefore, the number of polar groups generated in the developing step is small, which is an advantageous technique for lowering the dielectric constant. Epoxy monomers and acrylic monomers are used as curable components in curable compositions used in inkjet methods, and are cured by light irradiation or heat (Patent Document 3). In order to cope with 5G, it is necessary to further reduce polar groups such as carboxylic acid in the system of the curable composition. In the epoxy monomer, a hydroxy group remains at the time of polymerization, and in the acrylic monomer, polar groups are generated due to oxygen inhibition of radical polymerization, and thus, there is a problem in lowering the dielectric constant corresponding to 5G.

On the other hand, if a curable composition that does not generate polar groups upon curing is used for making a solder resist film in consideration of low dielectric constant, there is concern that the adhesiveness of the cured product to the conductor wiring of the wiring substrate will decrease. Thus, heat resistance, low dielectric constant and adhesiveness are required for the cured product that constitutes the solder resist film.

Patent Document 4 describes a curable inkjet composition, a cured product of the composition and an electronic component having the cured product. The composition comprises a filler having a Mohs hardness of 5 or more, at least either a multi-branched oligomer or a multi-branched polymer having an ethylenically unsaturated group, a thermosetting compound, and a photopolymerization initiator.

Patent Document 5 describes an active light-curable inkjet ink and an image formation method. The active light-curable inkjet ink has a reversible sol-gel phase transition depending on the temperature and contains a photopolymerizable compound, a gelatinizer, and a photoinitiator wherein a compound represented by the following general formula is contained as the photoinitiator at a content of 10 to 50 mass%: 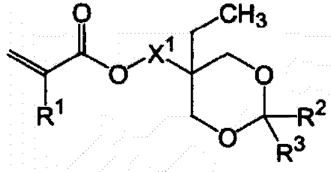 wherein each of R¹, R² and R³ independently represent a hydrogen atom, a methyl group or an ethyl group and X¹ is a single bond or a divalent linkage group.

Patent Document 6 describes a solder resist ink composition which comprises a photosensitive prepolymer having a carboxyl group and at least two ethylenically unsaturated bonds per molecule and having an acid value of 50 to 150 mg-KOH/g on a solid basis, a photopolymerization initiator having a melting point of 100°C or higher, a diluent, and a thermosetting ingredient comprising as the main component an epoxy compound having two or more epoxy groups per molecule.

### Citation List

### Patent Literatures

Patent Document 1: JP-A 2020-076052
Patent Document 2: JP-A 2010-34414
Patent Document 3: JP-A 2019-178288
Patent Document 4: JP 2019 178270 A
Patent Document 5: JP 2016 069571 A
Patent Document 6: WO 00/68740 A1

### Summary of Invention

### Technical Problem

The present invention has been made in view of the above problems and circumstances, and an object to be achieved is to provide a curable composition and a solder resist ink which provide a cured product having excellent adhesiveness and heat resistance and a low relative permittivity, and a printed circuit board using the same.

### Solution to Problem

In order to solve the above-mentioned problems, in the process of studying the causes of the above-mentioned problems, the present inventors have found that in a curable composition containing a (meth)acrylic monomer as a main component, a photopolymerization initiator, a thermosetting compound, and a gelling agent, the above-mentioned problems can be solved when the obtained cured product has a specific relative permittivity, and have reached the present invention. That is, the above problem according to the present invention is solved by the curable composition, solder resist ink and printed circuit board as defined in the appended claims.

### Advantageous Effects of Invention

According to the above means of the present invention, it is possible to provide a curable composition, a solder resist ink, and a printed circuit board using the same, which provide a cured product having excellent adhesiveness and heat resistance and a low relative permittivity. The expression mechanism or action mechanism of the effect of the present invention is not clear, but is assumed as follows.

The curable composition of the present invention contains a photopolymerizable (meth)acrylic monomer as a main component, so that the amount of polar groups in the cured product may be reduced, and the curable composition contains a gelling agent, so that the components in the curable composition are gelled to form a fine card house structure in the composition. It is considered that, as a result, the diffusion rate of oxygen or moisture entering from the outside becomes slow, and therefore, the generation of polar groups such as carboxylic acid or a hydroxy group, which are generated when the curable composition is cured, is further suppressed, thereby achieving a low dielectric constant (relative permittivity at 10 GHz is less than 2.90) and a low dielectric loss tangent of the obtained cured product.

Further, in the curable composition of the present invention, in addition to the above, a thermosetting compound is contained, and thermal polymerization is also used in combination, whereby a small amount of polar groups generated at the time of photopolymerization may be sealed, and adhesiveness to a circuit board and heat resistance may be improved.

### Description of Embodiments

The curable composition of the present invention is a curable composition containing a (meth)acrylic monomer as a main component and further containing a photoinitiator, a thermosetting compound, and a gelling agent, and is characterized in that the relative permittivity of the cured product of the curable composition at 10 GHz is less than 2.90, wherein the (meth)acrylic monomer includes a (meth)acrylic monomer (A1) having a molecular weight in the range of 200 to 1,500 and a ClogP value in the range of 3.5 to 7.0, the (meth)acrylate (A1) is contained in the range of 50 to 95% by mass with respect to the entire curable composition, the thermosetting compound has a thermosetting functional group selected from the group consisting of an isocyanate group, an epoxy group, a maleimide group, and an isocyanate group which is protected by a thermally dissociable blocking agent, and the gelling agent is selected from the group consisting of ketone waxes, ester waxes, higher fatty acids, higher alcohols, and fatty acid amides. These features are technical features common to or corresponding to each of the following embodiments.

As an embodiment of the curable composition of the present invention, from the viewpoint of facilitating adjustment of the amount of polar groups in the resulting cured product, it is preferred that the content of the thermosetting compound is in the range of 1 to 15% by mass of the total amount of the curable composition.

From the viewpoint of enhancing the dissolution stability of the gelling agent in the curable composition, the (meth)acrylic monomer contains a (meth)acrylic monomer having a molecular weight in the range of 200 to 1,500 and a ClogP value in the range of 3.5 to 7.0.

As an embodiment of the curable composition of the present invention, it is preferred that the thermosetting compound includes a multifunctional isocyanate compound in which the isocyanate group is protected by a thermally dissociable blocking agent, from the viewpoint that the resulting cured product has a lower relative permittivity and improved resistance to high temperature and humidity.

As an embodiment of the curable composition of the present invention, from the viewpoint of workability when making a cured product using the curable composition and from the viewpoint of reproducibility of fine lines when drawing by an inkjet method, it is preferable that the viscosity of the curable composition at 25 °C is in the range of 1 to 1 x 10⁴ Pa·s, and the phase transition temperature is 40 °C or more and less than 100 °C.

The solder resist ink of the present invention is characterized by containing the curable composition of the present invention.

The printed circuit board of the present invention is a printed circuit board including a substrate, a circuit pattern on the surface of the substrate, and a solder resist film on the circuit pattern, wherein the solder resist film is formed using the solder resist ink of the present invention.

As an embodiment of the printed circuit board of the present invention, it is preferable that the circuit pattern is composed of copper wiring, and the surface roughness Ra of the copper wiring is in the range of 0.1 to 2.0 µm from the viewpoint of adhesiveness of the solder resist film.

Hereinafter, the present invention, its constituent elements, and forms and embodiments of the present invention will be described. In the present invention, "to" is used in the sense of including the numerical values described before and after "to" as lower and upper limits.

### [Curable composition]

The curable composition of the present invention is a curable composition containing a (meth)acrylic monomer as a main component and further containing a photoinitiator, a thermosetting compound, and a gelling agent, and is characterized by a relative permittivity of the cured product of the curable composition at 10 GHz is less than 2.90, wherein the (meth)acrylic monomer includes a (meth)acrylic monomer (A1) having a molecular weight in the range of 200 to 1,500 and a ClogP value in the range of 3.5 to 7.0, the (meth)acrylate (A1) is contained in the range of 50 to 95% by mass with respect to the entire curable composition, the thermosetting compound has a thermosetting functional group selected from the group consisting of an isocyanate group, an epoxy group, a maleimide group, and an isocyanate group which is protected by a thermally dissociable blocking agent, and the gelling agent is selected from the group consisting of ketone waxes, ester waxes, higher fatty acids, higher alcohols, and fatty acid amides.

In the present invention, "(meth)acrylic" means acrylic or methacrylic, "(meth)acrylate" means acrylate or methacrylate, "(meth)acryloyloxy group ((meth)acryloyloxy group)" means an acryloyloxy group (acryloyloxy group) or a methacryloyloxy group (methacryloyloxy group).

The (meth)acrylic monomers contained in the curable composition of the present invention refer to (meth)acrylic acid and its derivatives that are not thermosetting compounds as described below. In other words, (meth)acrylic compounds that do not have thermosetting functional groups are referred to as (meth)acrylic monomers.

### <(Meth)acrylic monomer>

The (meth)acrylic monomers according to the present invention are radical polymerizable compounds having vinyl groups derived from (meth)acrylic acid, and are capable of radical polymerization by the action of active energy rays. The curable composition of the present invention contains a (meth)acrylic monomer as a main component. In this specification, the term "main component" refers to a component that accounts for more than 50% by mass of the total. Specifically, the content of (meth)acrylic monomer in the curable composition is 50 to 95% by mass of the entire curable composition, and 70 to 90% by mass is preferred.

By including a (meth)acrylic monomer as a main component, the relative permittivity in the resulting cured product may be within the above specified range. Also, by setting the upper limit of the content of (meth)acrylic monomer to the above value, the content of thermosetting compounds may be sufficiently secured, and a cured product with excellent adhesiveness to the substrate and heat resistance may be easily obtained.

Ester compounds of (meth)acrylic acid, i.e., (meth)acrylate and its derivatives, are preferred as (meth)acrylic monomers. (Meth)acrylate may be a monofunctional (meth)acrylate having one (meth)acryloyloxy group or a multifunctional (meth)acrylate having two or more (meth)acryloyloxy groups. The (meth)acrylic monomer may have functional groups other than (meth)acryloyloxy groups (but not thermosetting functional groups). The functional groups include a hydroxy group, a carboxy group, an imide group, an alkyl group, a cycloalkyl group, an alkyleneoxy group, an aromatic group, and a heterocyclic group. These functional groups are not considered thermosetting functional groups in the present invention, but may contribute to thermosetting by reacting with thermosetting functional groups possessed by thermosetting compounds under heat, as described below.

Examples of the monofunctional (meth)acrylate include isoamyl (meth)acrylate, stearyl (meth)acrylate, lauryl (meth)acrylate, octyl (meth)acrylate, decyl (meth)acrylate, isomyristyl (meth)acrylate, isostearyl (meth)acrylate, 2-ethylhexyl-diglycol (meth)acrylate, 2-hydroxybutyl (meth)acrylate, 2-(meth)acryloyloxyethyl hexahydrophthalic acid, butoxyethyl (meth)acrylate, ethoxydiethylene glycol (meth)acrylate, methoxydiethylene glycol (meth)acrylate, methoxypolyethylene glycol (meth)acrylate, methoxypropylene glycol (meth)acrylate, phenoxyethyl (meth)acrylate, tetrahydrofurfuryl (meth)acrylate, isobornyl (meth)acrylate, dicyclopentanyl (meth)acrylate, 2-hydroxyethyl (meth)acrylate, 2-hydroxypropyl (meth)acrylate, 2-hydroxy-3-phenoxypropyl (meth)acrylate, 2-(meth)acryloyloxyethylsuccinic acid, 2-(meth)acryloyloxyethylphthalic acid, 2-(meth)acryloyloxyethyl-2-hydroxyethyl-phthalic acid, and t-butylcyclohexyl (meth)acrylate.

Among polyfunctional (meth)acrylates, bifunctional (meth)acrylates include, for example, di(meth)acrylates having a (meth)acryloyloxy group at the carbon atom side end of the polyoxyalkylene group and a (meth)acryloyl group at the oxygen atom side end are included. A polyoxyalkylene group is a divalent group having an oxyalkylene group as a repeating unit. The oxyalkylene group which is a repeating unit includes an oxyalkylene group having 1 to 4 carbon atoms. The alkylene group of the oxyalkylene group may be linear or branched. For example, the propylene group may be -(CH₂)₃-, -CH(CH₃)-CH₂-, and -CH(CH₂CH₃)-. The repeating number of the oxyalkylene group (hereinafter referred to as "n") is 2 to 20, preferably 3 to 14, more preferably 3 to 10.

As a di(meth)acrylate having a polyoxyalkylene group, specific examples of a compound having an oxyethylene group as an oxyalkylene group include polyethylene glycol di(meth)acrylates such as diethylene glycol di(meth)acrylate, triethylene glycol di(meth)acrylate, and tetraethylene glycol di(meth)acrylate. Examples of a compound having a propylene group as an alkylene group include polypropylene glycol di(meth)acrylates such as dipropylene glycol di(meth)acrylate and tripropylene glycol di(meth)acrylate. Compounds having a repeating unit of an oxyalkylene group having 4 carbon atoms such as polytetramethylene glycol di(meth)acrylate are also included.

Examples of the bifunctional (meth)acrylate include a compound in which (meth)acrylic acid is ester bonded to a diol such as 1,4-butanediol di(meth)acrylate, 1,6-hexanediol di(meth)acrylate, 1,9-nonanediol di(meth)acrylate, 1,10-decanediol di(meth)acrylate, neopentyl glycol di(meth)acrylate, tricyclodecane dimethanol di(meth)acrylate, bisphenol A propylene oxide (hereinafter, also referred to as "PO") or ethylene oxide (hereinafter, also referred to as "EO") adduct di(meth)acrylate, bisphenol F PO or EO adduct di(meth)acrylate, and hydroxypivalic acid neopentyl glycol di(meth)acrylate.

Examples of the tri- or higher-functional acrylate include trimethylolpropane tri(meth)acrylate, pentaerythritol tri(meth)acrylate, pentaerythritol tetra(meth)acrylate, dipentaerythritol hexa(meth)acrylate, ditrimethylolpropane tetra(meth)acrylate, glycerol propoxy tri(meth)acrylate, and pentaerythritol ethoxy tetra(meth)acrylate.

The (meth)acrylate may be modified. Examples of (meth)acrylates that are modified include ethylene oxide (EO) modified or propylene oxide (PO) modified (meth)acrylates. EO-modified or PO-modified (meth)acrylates include, for example, EO or PO-modified trimethylolpropane tri(meth)acrylate, EO or PO-modified pentaerythritol tetra(meth)acrylate, and EO or PO-modified neopentyl glycol di(meth)acrylate, EO or PO-modified 1,6-hexanediol di(meth)acrylate. The number of EO or PO in EO-modified or PO-modified (meth)acrylate corresponds to the number of repeats n of the oxyalkylene group in the polyoxyalkylene group above. It is preferably 1 to 5, and more preferably 2 to 4.

Examples of modified (meth)acrylates also include caprolactone-modified (meth)acrylates including caprolactone-modified trimethylolpropane tri(meth)acrylate, and caprolactam-modified (meth)acrylates including caprolactam-modified dipentaerythritol hexa(meth)acrylate.

The (meth)acrylate may be a polymerizable oligomer. Examples of (meth)acrylates that are polymerizable oligomers include epoxy (meth)acrylate oligomers, aliphatic urethane (meth)acrylate oligomers, aromatic urethane (meth)acrylate oligomers, polyester (meth)acrylate oligomers, and linear (meth)acrylic oligomers.

The (meth)acrylate may be a (meth)acrylate compound having an imide group. The use of a (meth)acrylate having an imide group is expected to improve the high-temperature and high-humidity resistance of the cured product. In addition, in the case of (meth)acrylate having an imide group, the imide group has a high polarity, so the cured product has strong metal adhesiveness. For example, when it is used for producing a solder resist film, it is expected to improve adhesiveness to a circuit board. In addition, since it itself has a strong cohesive force, it has little effect on metal adhesiveness even under high humidity.

As a (meth)acrylate having an imido group, imido acrylates or imido metacrylates described in JP-A 10-36462 and JP-A 11-21470 are examples.

In the present invention, one of these (meth)acrylates may be used alone, or two or more may be used in combination. The molecular weight of these (meth)acrylates is not restricted, but from the viewpoint of ejection stability in inkjet printing, a molecular weight of 200 to 1,500 is preferred, and 300 to 1,200 is more preferred.

However, the curable composition of the present invention contains, as a (meth)acrylic monomer, a (meth)acrylic monomer having a molecular weight in the range of 200 to 1,500 and a ClogP value in the range of 3.5 to 7.0 among the above-described (meth)acrylic monomers in view of relative permittivity, stable dissolution of a gelling agent, and stable ejection in inkjet. Hereinafter, a (meth)acrylic monomer having a molecular weight in the range of 200 to 1,500 and a ClogP value in the range of 3.5 to 7.0 is also referred to as a (meth)acrylic monomer (A1).

When the (meth)acrylic monomer (A1) has a molecular weight in the range of 200 to 1,500, the (meth) acrylic monomer (A1) has the above-described advantages, and when the (meth)acrylic monomer has a ClogP of 3.5 or more, a large number of hydrophobic structures are present in the (meth)acrylic monomer, thereby making it difficult for moisture to enter the (meth)acrylic monomer during polymerization or when the (meth)acrylic monomer becomes a cured product. This suppresses the amount of polar groups in the cured product, thereby improving the relative permittivity. When the (meth)acrylic monomer (A1) has a ClogP of 7.0 or less, the solubility stability of the gelling agent is improved, and a desired card house structure may be formed. This suppresses the generation of polar groups due to oxygen or water during polymerization and improves the relative permittivity.

The (meth)acrylic monomer (A1) is a (meth)acrylate having a molecular weight in the range of 200 to 1,500 and a ClogP value in the range of 3.5 to 7.0. The (meth)acrylic monomer (A1) preferably has a ClogP value in the range of 4.0 to 6.0. In addition, the (meth)acrylic monomer (A1) may be a (meth)acrylate having a polyoxyalkylene group (for example, n = 2 to 10) in which an oxyalkylene group selected from an oxyethylene group and an oxypropylene group is a repeating unit.

Examples of the (meth)acrylic monomer (A1) include 1,10-decanediol dimethacrylate (molecular weight: 310, ClogP: 5.8), tricyclodecane dimethanol diacrylate (molecular weight: 304, ClogP: 4.7), tricyclodecane dimethanol dimethacrylate (molecular weight: 332, ClogP: 5.3), 3PO-modified trimethylolpropane triacrylate (molecular weight: 470, ClogP: 4.0 to 5.0), dipentaerythritol pentaacrylate (molecular weight: 524, ClogP: 3.8), 6EO-modified trimethylolpropane triacrylate (molecular weight: 560, ClogP: 3.6), bisphenol A 3EO-modified diacrylate (molecular weight: 468, ClogP: 5.9), and bisphenol F 4EO-modified diacrylate (molecular weight: 499, ClogP: 5.0 to 5.2).

The (meth)acrylate (A1) is contained in the range of 50 to 95% by mass, and preferably in the range of 70 to 90% by mass with respect to the entire curable composition in terms of stable ejection and stable dissolution of the gelling agent. The (meth)acrylic monomer contained in the curable composition may be composed only of the (meth)acrylic monomer (A1), or may be a combination of the (meth)acrylic monomer (A1) and another (meth)acrylic monomer other than the (meth)acrylic monomer (A1). Examples of the other (meth)acrylic monomer include a (meth)acrylate having a molecular weight in the range of 200 to 1,500 and a ClogP value outside the range of 3.5 to 7.0.

Here, the "logP value" as used in the present invention is a coefficient indicating the affinity of an organic compound for water and 1-octanol. The 1-octanol/water partition coefficient P is the partition equilibrium when a trace amount of the compound is dissolved as a solute in the solvent of the two liquid phases of 1-octanol and water, and it is the ratio of the equilibrium concentrations of the compound in each solvent, and it is expressed as their logarithm logP to the base 10. That is, the "logP value" is the logarithmic value of the 1-octanol/water partition coefficient P, and is known as an important parameter representing the hydrophilicity/hydrophobicity of a molecule.

A "ClogP value" is a logP value obtained by calculation. The ClogP value may be calculated by a fragment method or an atomic approach method. More specifically, in order to calculate the ClogP value, the fragment method described in the literature (C. Hansch, and A. Leo, "Substituent Constants for Correlation Analysis in Chemistry and Biology" (John Wiley & Sons, New York, 1969)) or the following commercially available software package 1 or 2 may be used.
Software package 1: MedChem Software (Release 3.54, August 1991; Medicinal Chemistry Project, Pomona College, Claremont, CA); and
Software Package 2: Chem Draw Professional 16.0. (Perkin Elmer).

The ClogP values given in the present specification are "ClogP values" calculated using the software package 2.

As the other (meth)acrylic monomer to be used in combination with the (meth)acrylic monomer (A1), a (meth)acrylate having a molecular weight in the range of 200 to 1,500 and containing 3 to 14 repeating units of oxyethylene group represented by (-CH₂-CH₂-O-) in the molecule, or a (meth)acrylate having a molecular weight in the range of 200 to 1,500 and containing 2 to 14 repeating unit of an oxypropylene group (provided that the ClogP value is outside the range of 3.5 to 7.0) is preferable in terms of ejection stability, dissolution stability of the gelling agent, and cure shrinkage (adhesiveness). Hereinafter, (meth)acrylate having a polyoxyalkylene group satisfying the above conditions is also referred to as a (meth)acrylic monomer (A2).

Examples of the (meth)acrylic monomer (A2) include polyethylene glycol diacrylate (n = 9, molecular weight: 508, ClogP: 0.2 to 0.5), 4EO-modified hexanediol diacrylate (molecular weight: 358, ClogP: 2.5), 4EO-modified pentaerythritol tetraacrylate (molecular weight: 528, ClogP: 2.3), nonylphenol 2PO-modified acrylate (molecular weight: 390, ClogP: 7.6), and dipropylene glycol diacrylate (molecular weight: 242, ClogP: 2.0).

The (meth)acrylic monomer (A2) may be used alone or in combination of two or more thereof. The (meth)acrylic monomer (A2) may constitute the (meth)acrylic monomer contained in the curable composition alone or in combination with another (meth)acrylic monomer. In this case, the (meth)acrylic monomer (A2) is preferably used in combination with the (meth)acrylic monomer (A1), but may be used in combination with another (meth)acrylic monomer other than the (meth)acrylic monomer (A1).

When the (meth)acrylic monomer (A2) is used, the (meth)acrylic monomer (A2) is preferably contained in a range of 30 to 70% by mass with respect to the entire curable composition from the viewpoint of cure shrinkage (adhesiveness) of the cured product. Further, when the (meth)acrylic monomer (A1) and the (meth)acrylic monomer (A2) are used in combination, the content of the (meth)acrylic monomer (A2) is preferably 1.5 to 60% by mass, more preferably 5 to 30% by mass, and even more preferably 10 to 20% by mass with respect to the entire curable composition. In this case, the content of the (meth)acrylic monomer (A1) is preferably 30 to 90% by mass, more preferably 70 to 90% by mass with respect to the entire curable composition.

The (meth)acrylic monomer may contain the (meth)acrylic monomer (A1) and another (meth)acrylic monomer other than the (meth)acrylic monomer( A2). The other (meth)acrylic monomer preferably has a molecular weight in the range of 200 to 1,500, and examples thereof include dicyclopentanyl acrylate (molecular weight: 206, ClogP: 3.1).

The other (meth)acrylic monomer is preferably used in combination with the (meth)acrylic monomer (A1). In this case, the content of the other (meth)acrylic monomer is preferably 5 to 30% by mass and more preferably 10 to 20% by mass with respect to the entire curable composition.

### <Other photopolymerizable compounds>

In addition to the (meth)acrylic monomer, the curable composition of the present invention may contain other photopolymerizable compound. Other photopolymerizable compounds may be any compounds that cause a polymerization or cross-linking reaction upon irradiation with active energy rays to polymerize or cross-link, thereby curing the curable composition. Examples of other photopolymerizable compounds include radical polymerizable compounds and cationic polymerizable compounds other than (meth)acrylic monomers. Other photopolymerizable compounds may be monomers, polymerizable oligomers, prepolymers, or mixtures thereof. Only one or more of the other photopolymerizable compounds may be included in the curable composition. The cationic polymerizable compounds may be epoxy compounds, vinylether compounds, and oxetane compounds. Only one type of cationic polymerizable compound may be included in the curable composition, and two or more types may be included.

Since the curable compositions according to the present invention are mainly composed of (meth)acrylic monomers from the viewpoint of dielectric constant control, it is preferable to contain 0 to 2 other photopolymerizable compounds, and it is most preferable to contain no more than 1 type. It is most preferable to contain no other photopolymerizable compounds. The content of other photopolymerizable compounds in the curable composition may be, for example, 10% by mass or less, 5% by mass or less is preferred, and 0% by mass is especially preferred with respect to the total amount of the curable composition.

### <Photopolymerization initiator>

The photopolymerization initiator according to the present invention is an essential component contained in the curable composition in order to photopolymerize the (meth)acrylic monomer. As the photopolymerization initiator, a photoradical initiator is preferable. When a cationic polymerizable compound is used as the other photopolymerizable compound in addition to the (meth)acrylic monomer, a photoacid generator is preferably used in addition to the photoradical initiator.

The curable composition of the present invention may contain only one kind of photopolymerization initiator or two or more kinds of photopolymerization initiators. The photopolymerization initiator may be a combination of both a photoradical initiator and a photoacid generator.

The photoradical initiator includes a cleavage type radical initiator and a hydrogen abstraction type radical initiator. Examples of the cleavage type radical initiator include an acetophenone-based initiator, a benzoin-based initiator, an acylphosphine oxide-based initiator, and benzyl and methylphenyl glyoxy esters.

Examples of the acetophenone-based initiator include diethoxyacetophenone, 2-hydroxy-2-methyl-1-phenylpropan-1-one, benzyl dimethyl ketal, 1-(4-isopropylphenyl)-2-hydroxy-2-methylpropan-1-one, 4-(2-hydroxyethoxy)phenyl-(2-hydroxy-2-propyl)ketone, 1-hydroxycyclohexyl-phenyl ketone, 2-methyl-2-morpholino (4-thiomethylphenyl)propan-1-one, 2-benzyl-2-dimethylamino-1-(4-morpholinophenyl)-butanone and 2-dimethylamino-2-(4-methylbenzyl)-1-(4-morpholin-4-yl-phenyl)-butan-1-one.

Examples of the benzoin-based initiator include benzoin, benzoin methyl ether, and benzoin isopropyl ether.

Examples of the acylphosphine oxide-based initiator include 2,4,6-trimethylbenzoyldiphenylphosphine oxide and bis (2,4,6-trimethylbenzoyl)phenylphosphine oxide.

Examples of the hydrogen abstraction type radical initiator include a benzophenone-based initiator, a thioxanthone-based initiator, an aminobenzophenone-based initiator, 10-butyl-2-chloroacridone, 2-ethylanthraquinone, 9,10-phenanthrenequinone, and camphorquinone.

Examples of the benzophenone initiator include benzophenone, methyl o-benzoylbenzoate, 4-phenylbenzophenone, 4,4'-dichlorobenzophenone, hydroxybenzophenone, 4-benzoyl-4'-methyl-diphenyl sulfide, acrylated benzophenone, 3,3',4,4'- tetra(t-butylperoxycarbonyl)benzophenone, and 3,3'-dimethyl-4-methoxybenzophenone.

Examples of the thioxanthone-based initiator include 2-isopropylthioxanthone, 2,4-dimethylthioxanthone, 2,4-diethylthioxanthone, and 2,4-dichlorothioxanthone. Examples of the aminobenzophenone-based initiator include Michler's ketone and 4,4'-diethylaminobenzophenone.

Examples of the photoacid generator include compounds described in "Organic Materials for Imaging" edited by Organic Electronics Materials Research Association, Bunshin Shuppan (1993), pp. 187 to 192.

The content of the photopolymerization initiator may be in the range in which the curable composition may be sufficiently cured, and for example, may be in the range of 0.01 to 10% by mass, and preferably 0.1 to 5% by mass, with respect to the total mass of the curable composition of the present invention.

The photopolymerization initiator may be used in combination of two types of photopolymerization initiators having different absorption sensitivity wavelengths. Examples of the combination of the photopolymerization initiators include a combination of an acylphosphine oxide-based initiator and a thioxanthone-based initiator, and a combination of a peroxide-based initiator and a thioxanthone-based initiator.

Examples of commercially available products of the photopolymerization initiator include Omnirad TPO H (manufactured by IGM, Inc., 2,4,6-trimethylbenzoyldiphenylphosphine oxide), Omnirad 819 (manufactured by IGM, Inc., bis (2,4,6-trimethylbenzoyl)phenylphosphine oxide), Omnirad 379 (manufactured by IGM, Inc., 2-dimethylamino-2-(4-methylbenzyl)-1-(4-morpholin-4-yl-phenyl)-butan-1-one), and Omnirad ITX (manufactured by IGM, Inc., 2-isopropylthioxanthone).

The curable composition of the present invention may further contains, if necessary, a photopolymerization initiator aid, which may be a tertiary amine compound, preferably an aromatic tertiary amine compound. Examples of the aromatic tertiary amine compound include N,N-dimethylaniline, N,N-diethylaniline, N,N-dimethyl-p-toluidine, N,N-dimethylamino-p-benzoic acid ethyl ester, N,N-dimethylamino-p-benzoic acid isoamylethyl ester, N,N-dihydroxyethylaniline, triethylamine, and N,N-dimethylhexylamine. These compounds may be used alone or in combination of two or more.

Examples of commercially available products of the photopolymerization initiator aid include Genocure EPD (manufactured by Rahn A.G., N,N-dimethylamino-p-benzoic acid ethyl ester).

### <Thermosetting Compound>

The curable composition of the present invention contains a (meth)acrylic monomer as a radical polymerizable compound as a main component, and further contains a thermosetting compound which is cured by heat. The curable composition of the present invention contains a thermosetting compound, and thus it is possible to improve adhesiveness with a circuit board and heat resistance of the obtained cured product. The curable composition of the present invention becomes a cured product by reacting and curing the (meth)acrylic monomer by active energy ray irradiation and the thermosetting compound by heating.

The content of the thermosetting compound in the curable composition is an amount in which the curable composition may contain the (meth)acrylic monomer as a main component, and is preferably 1 to 15% by mass, and more preferably 2 to 10% by mass, with respect to the entire curable composition. When the content of the thermosetting compound is less than 1% by mass, adhesiveness and heat resistance may be insufficient. When the content of the thermosetting compound is more than 15% by mass, thermal stability may be reduced when the temperature is set to the gelation temperature or higher, and an unreacted thermosetting compound may react with water to generate a polar group.

The thermosetting compound according to the present invention refers to a compound having a thermosetting functional group selected from the group consisting of an isocyanate group, an epoxy group, a maleimide group, and an isocyanate group which is protected by a thermally dissociable blocking agent, and examples of the thermosetting functional group include functional groups cited in reviews such as "Refinement of Heat-Curable Polymers" (Takeshi Endo, C. M. C. Co., Ltd., 1986), "Handbook of Latest Binder Technology", Chapter II-I (Yuji Harasaki, United Engineering Center, 1985), "Synthesis, Design, and New Application Development of Acrylic Resins" (Takayuki Otsu, Chubu Management Development Center, 1985), and "Functional Acrylic Resins" (Eizo Omori, Techno System, 1985). Specifically, the thermosetting functional group is preferably at least one selected from the group consisting of an isocyanate group, an epoxy group, and a maleimide group in view of the thermosetting property.

The thermosetting compound according to the present invention may contain a (meth)acrylate structure, and a (meth)acrylate having a thermosetting functional group is treated as a thermosetting compound. The thermosetting in the thermosetting compound according to the present invention may be performed by a reaction between thermosetting functional groups contained in the thermosetting compound, or may be performed by a reaction between a thermosetting functional group contained in the thermosetting compound and the above-described functional group contained in the (meth)acrylate as a main component.

### (Isocyanate group)

Thermosetting compounds with an isocyanate group include, for example, multifunctional isocyanate compounds having two or more isocyanate groups in the molecule.

Specific examples of the polyfunctional isocyanate include: aromatic polyisocyanates such as 2,4-tolylene diisocyanate (2,4-TDI), 2,6-tolylene diisocyanate (2,6-TDI), 4,4'-diphenylmethane diisocyanate (4,4'-MDI), 2,4'-diphenylmethane diisocyanate (2,4'-MDI), 1,4-phenylene diisocyanate, xylylene diisocyanate (XDI), tetramethylxylylene diisocyanate (TMXDI), tridine diisocyanate (TODI), 1,5-naphthalene diisocyanate (NDI); aliphatic polyisocyanates such as hexamethylene diisocyanate (HDI), trimethylhexamethylene diisocyanate (TMHDI), lysine diisocyanate, and norbornane diisocyanate methyl (NBDI); alicyclic polyisocyanates such as transcyclohexane-1,4-diisocyanate, isophorone diisocyanate (IPDI), H6XDI (hydrogenated XDI), H12MDI (hydrogenated MDI), and H6TDI (hydrogenated TDI); polyisocyanates such as polymethylene polyphenylene polyisocyanates.

These polyfunctional isocyanate compounds may be multimerized, and examples of the multimer include a biuret form and an isocyanurate form, both of which are trimers, and the polyfunctional isocyanate compound may be modified into a carbodiimide-modified product.

The (meth)acrylate compound having an isocyanate group may be any compound having an isocyanate group and a (meth)acryloyloxy group in the molecule, and examples thereof include 2-(meth)acryloyloxyethyl isocyanate, 2-isocyanatoethyl (meth)acrylate, 2-(meth)acryloyloxyethyl isocyanate, 2-isocyanatoethyl (meth)acrylate, 3-isocyanatopropyl (meth)acrylate, and reaction products of hydroxyalkyl (meth) acrylates such as hydroxyethyl (meth)acrylate with polyisocyanates such as tolylene diisocyanate.

The thermosetting compound having an isocyanate group is preferably a blocked isocyanate compound (thermally dissociable blocked isocyanate compound) in which the isocyanate group is protected by a thermally dissociable blocking agent, from the viewpoint of lowering the relative permittivity of the cured product and improving the resistance to high temperature and high humidity. Since the reactivity of the isocyanate group of the thermally dissociable blocked isocyanate compound is suppressed by the protection of the blocking agent at a temperature lower than the dissociation temperature of the blocking agent, the curable composition containing the thermally dissociable blocked isocyanate compound has high thermal stability, and since the blocking agent is dissociated by heating to the dissociation temperature or higher, the isocyanate group becomes reactive.

The blocked isocyanate compound is preferably a thermally dissociable blocked isocyanate compound of a polyfunctional isocyanate compound. In the case of polyfunctional blocked isocyanate compounds having isocyanate groups protected by blocking agents, in particular, the isocyanurate ring generated from the trimerization reaction of isocyanate has higher thermal stability than urethane and urea bonds, and is excellent in heat resistant. Further, when a polyfunctional blocked isocyanate compound is used, a network structure having isocyanurate rings is formed, which further improves heat resistance and makes it less susceptible to humidity at high temperatures.

The thermally dissociable blocking agent is preferably at least one compound selected from the group consisting of an oxime-based compound, a pyrazole-based compound, and an active ethylene-based compound in terms of ink storage stability and thermal dissociability of the thermosetting compounds.

Examples of the oxime-based compound include formamide oxime, acetoaldoxime, acetoxime, methyl ethyl ketone oxime (MEKO), and cyclohexanone oxime.

Examples of the pyrazole-based compound include pyrazole, 3-methylpyrazole, and 3,5-dimethylpyrazole (DMP).

Examples of the active ethylene-based compound include dimethyl malonate, diethyl malonate (DEM), methyl acetoacetate, ethyl acetoacetate, and acetylacetone.

Caprolactams such as ε-caprolactam may also be used as a thermally dissociable blocking agent.

Examples of the blocked isocyanate compound having an isocyanate group protected by a blocking agent include 2-[(3,5-dimethylpyrazolyl)caibonylamino]ethyl (meth)acrylate (Karenz MOI-BP, manufactured by Showa Denko K. K.), 2-[(3-butylidene)aminooxycarbonylamino]ethyl (meth)acrylate, and 2-(0-[1'-methylpropylideneamino]carboxyamino)ethyl (meth)acrylate (Karenz MOI-BM, manufactured by Showa Denko K. K.). In the parentheses after the compound names, alternative commercial products (product names and manufacturers) are shown, and the same applies to the following polyfunctional blocked isocyanate compounds having an isocyanate group protected by a blocking agent.

Examples of the polyfunctional blocked isocyanate compound having an isocyanate group protected by the blocking agent include DMP-blocked HDI biuret (Trixene BI7961, manufactured by LANXESS Co., Ltd.), DMP-blocked HDI trimer (Trixene BI7982, manufactured by LANXESS Co., Ltd.), DMP- and DEM-blocked HDI trimer (Trixene BI7992, manufactured by LANXESS Co., Ltd.), MEKO-blocked HDI trimer (PU5211, manufactured by Leeson Polyurethanes), and ε-caprolactam-blocked polyfunctional isocyanate (VESTANATBI1186A, manufactured by Evonik Co., Ltd.).

One kind of the blocking agent may be used alone, or two or more kinds thereof may be used in combination, and one kind or two or more kinds of thermally dissociable blocked isocyanate compounds blocked with one kind or two or more kinds of blocking agents may be used as the thermosetting compound.

Examples of commercially available thermally dissociable blocked isocyanate compounds include, in addition to the above, MF-K60X (manufactured by Asahi Kasei Chemicals Co., Ltd.), VPLS2253, and BL4265SN (both manufactured by Sumika Bayer Urethane Co., Ltd.).

### (Epoxy group)

Examples of the thermosetting compound having an epoxy group include various chain epoxy group-containing monomers (e.g., glycidyl (meth)acrylate, β-methylglycidyl (meth)acrylate, glycidyl vinyl ether, allyl glycidyl ether), various (2-oxo-1,3-oxolane) group-containing vinyl monomers (e.g., (2-oxo-1,3-oxolane)methyl (meth)acrylate), various alicyclic epoxy group-containing vinyl monomers (e.g., 3,4-epoxycyclohexyl (meth)acrylate, 3,4-epoxycyclohexylmethyl (meth)acrylate, 3,4-epoxycyclohexylethyl (meth)acrylate), bisphenol A diglycidyl ether, bisphenol F diglycidyl ether, bisphenol S diglycidyl ether, brominated bisphenol A diglycidyl ether, brominated bisphenol F diglycidyl ether, hydrogenated bisphenol S diglycidyl ether, 1,4-butanediol diglycidyl ether, 1,6-hexanediol diglycidyl ether, glycerin triglycidyl ether, trimethylolpropane triglycidyl ether, polyethylene glycol diglycidyl ethers, polypropylene glycol diglycidyl ethers; polyglycidyl ethers of polyether polyols obtained by adding one or more alkylene oxides to aliphatic polyhydric alcohols such as ethylene glycol, propylene glycol, and glycerin; diglycidyl esters of aliphatic long-chain dibasic acids; monoglycidyl ethers of aliphatic higher alcohols; monoglycidyl ethers of phenol, cresol, butylphenol or polyether alcohols obtained by adding alkylene oxides thereto; and glycidyl esters of higher fatty acids.

Further, examples of the thermosetting compound having an epoxy group include a compound having a (meth)acryloyloxy group and an epoxy group, and a partially (meth)acrylated epoxy compound. Examples of the compound having a (meth)acryloyloxy group and an epoxy group include glycidyl (meth)acrylate and 4-hydroxybutyl (meth)acrylate glycidyl ether.

The partially (meth)acrylated epoxy compound may be obtained by reacting an epoxy compound with (meth)acrylic acid in the presence of a catalyst according to a conventional method. Examples of the epoxy compound that may be used for the partially (meth)acrylated epoxy compound include a novolak epoxy compound and a bisphenol epoxy compound.

Examples of the novolak type epoxy compound include phenol novolak type epoxy compounds, cresol novolak type epoxy compounds, biphenyl novolak type epoxy compounds, trisphenol novolak type epoxy compounds, and dicyclopentadiene novolak type epoxy compounds. Examples of the bisphenol type epoxy compound include bisphenol A type epoxy compounds, bisphenol F type epoxy compounds, 2,2'-diallyl bisphenol A type epoxy compounds, hydrogenated bisphenol type epoxy compounds, and polyoxypropylene bisphenol A type epoxy compounds. It is possible to obtain an epoxy compound having a desired acrylation ratio by appropriately changing the blending amount of the epoxy compound and the (meth) acrylic acid.

### (Maleimide group)

Examples of the thermosetting compound having a maleimide group include N-methylmaleimide, N-ethylmaleimide, N-hexylmaleimide, N-propylmaleimide, N-butylmaleimide, N-octylmaleimide, N-dodecylmaleimide, N-cyclohexylmaleimide, N-phenylmaleimide, N-p-carboxyphenylmaleimide, N-p-hydroxyphenylmaleimide, N-p-chlorophenylmaleimide, N-p-tolylmaleimide, N-p-xylylmaleimide, N-o-chlorophenylmaleimide, N-o-tolylmaleimide, N-benzylmaleimide, N-2,5-diethylphenylmaleimide, N-2,5-dimethylphenylmaleimide, N-m-tolylmaleimide, N-α-naphthylmaleimide, N-o-xylylmaleimide, N-m-xylylmaleimide, bismaleimidomethane, 1,2-bismaleimidoethane, 1,6-bismaleimidohexane, bismaleimidododecane, N,N'-m-phenylenedimaleimide, N,N'-p-phenylenedimaleimide, 4,4'-bismaleimidodiphenyl ether, 4,4'-bismaleimidodiphenylmethane, 4,4'-bismaleimido-di(3-methylphenyl)methane, 4,4'-bismaleimido-di(3-ethylphenyl)methane, 4,4'-bismaleimido-di(3-methyl-5-ethyl-phenyl)methane, N,N'-(2,2-bis-(4-phenoxyphenyl)propane)dimaleimide, N,N'-2,4-tolylenediimide, N,N'-2,6-tolylenedimaleimide, N,N'-m-xylylenedimaleimide, and bisphenol A diphenyl ether bismaleimide. Among these, bismaleimide is preferred.

### (Other thermosetting functional groups)

Examples of the thermosetting compound include a thermosetting compound having a functional group other than the above-described thermosetting functional group. For example, an oxetanyl group or an oxazoline group may be cited.

Examples of the thermosetting compound having an oxetanyl group include oxetane (meth)acrylate. Commercially available products of such compounds include trade names of OXE-10 and OXE-30 manufactured by Osaka Organic Chemical Co., Ltd.

Examples of the thermosetting compound having an oxazoline group include 2-isopropenyl-2-oxazoline, 2-isopropenyl-4-methyl-2-oxazoline, 2-isopropenyl-5-ethyl-2-oxazoline, 2-vinyl-2-oxazoline, 2-vinyl-4-methyl-2-oxazoline, 2-vinyl-5-methyl-2-oxazoline, and monomers having a substituent on the oxazoline group of these oxazoline group-containing monomers.

### <Gelling agent>

The curable composition of the present invention contains a gelling agent as an essential component. By containing the gelling agent, the curable composition of the present invention suppresses the generation of a polar group when the curable composition is cured by light and heat as described above, and achieves a low relative permittivity of the obtained cured product. In addition, since the gelling agent is present in the obtained cured product, it is possible to prevent the penetration of oxygen or moisture into the cured product. From such a viewpoint, the gelling agent is preferably held in a state of being uniformly dispersed in the cured product.

From the viewpoint of enhancing the above effect, ketone waxes, ester waxes, higher fatty acids, higher alcohols and fatty acid amides are used, ketone waxes and ester waxes are preferred, and ketone waxes represented by the following Formula (G1) and ester waxes represented by the following Formula (G2) are more preferred.

Further, gelling agents described in JP-A 2018 -506594, JP-A 2015-509996, JP-A 2006-193745, and JP-A 2011 -225876 may also be used.

The gelling agent according to the present invention is preferably at least one compound among compounds represented by the following Formula (G1) or (G2) in that the gelling agent is dispersed in the cured product (cured film) without inhibiting the curability of the curable composition. Further, in inkjet printing using the curable composition as an ink, it is preferable in that it has good pinning properties, enables drawing in which fine lines and film thickness are compatible, and is excellent in fine line reproducibility.

Formula (G1): R₁-CO-R₂

Formula (G2): R₃-COO-R₄

Wherein, R₁ to R₄ each independently represent an aliphatic hydrocarbon group which has a linear portion having 12 or more carbon atoms and may have a branch.

The compound represented by Formula (G1) is a ketone wax in which R₁ and R₂ are bonded to both sides of the carbonyl group (-C(=O)-). The compound represented by Formula (G2) is an ester wax in which R₃ and R₄ are bonded to both sides of an ester group (-C(=O)O-). In the ketone wax represented by Formula (G1) or the ester wax represented by Formula (G2), R₁ and R₂ or R₃ and R₄ each independently represent a linear or branched aliphatic hydrocarbon group having 12 or more carbon atoms, so that the crystallinity of the gelling agent is further improved and the water resistance is improved, and a sufficient space is produced in the card house structure. Therefore, each component in the curable composition is likely to be sufficiently included in the space, and the pinning property when used as an ink is further enhanced.

R₁ to R₄ may be a saturated aliphatic hydrocarbon group or an unsaturated aliphatic hydrocarbon group, as long as they have the above structures. Preferably, each of R₁ to R₄ independently has 26 or less carbon atoms. When the number of carbon atoms in R₁ to R₄ is 26 or less, the melting point of the gelling agent does not excessively increase, so that the ink need not be excessively heated when the curable composition is ejected as ink. From the above viewpoint, it is particularly preferable that R₁ and R₂ or R₃ and R₄ each are independently a linear aliphatic hydrocarbon group having 12 or more and 23 or less carbon atoms.

Further, when the gelation temperature of the curable composition is increased and the curable composition is used as an ink, from the viewpoint of gelling the ink more rapidly after landing, it is preferable that either R₁ or R₂ or either R₃ or R₄ is a saturated alkyl group having 12 to 23 carbon atoms. From the above viewpoint, it is more preferable that both R₁ and R₂ or both R₃ and R₄ are saturated alkyl groups having 12 to 23 carbon atoms.

Examples of the ketone wax represented by Formula (G1) include dilignoceryl ketone (C24-C24), dibehenyl ketone (C22-C22), distearyl ketone (C18-C18), dieicosyl ketone (C20-C20), dipalmityl ketone (C16-C16), dimyristyl ketone (C14-C14), dilauryl ketone (C12-C12), lauryl myristyl ketone (C12-C14), lauryl palmityl ketone (C12-C16), myristyl palmityl ketone (C14-C16), myristyl stearyl ketone (C14-C18), myristyl behenyl ketone (C14-C22), palmityl stearyl ketone (C16-C18), palmityl behenyl ketone (C16-22), and stearyl behenyl ketone (C18-C22). The carbon number in parentheses represents the carbon number of each of the two hydrocarbon groups separated by the carbonyl group.

Examples of commercially available products of the ketone wax represented by Formula (G1) include Stearonne (manufactured by Alfa Aeser; Stearonne), 18-Pentatriacontanon (manufactured by Alfa Aeser), Hentriacontan-16-on (manufactured by Alfa Aeser), and Kao wax T-1 (manufactured by Kao Corporation).

Examples of the ester wax represented by Formula (G2) include behenyl behenate (C21-C22), icosyl icosanoate (C19-C20), stearyl stearate (C17-C18), palmityl stearate (C17-C16), lauryl stearate (C17-C12), cetyl palmitate (C15-C16), stearyl palmitate (C15-C18), myristyl myristate (C13-C14), cetyl myristate (C13-C16), octyldodecyl myristate (C13-C20), stearyl oleate (C17-C18), stearyl erucate (C21-C18), stearyl linoleate (C17-C18), behenyl oleate (C18-C22), and arachidyl linoleate (C17-C20). The carbon number in parentheses represents the carbon number of each of the two hydrocarbon groups separated by the ester group.

Examples of commercially available products of the ester wax represented by Formula (G2) include UNISTAR-M-2222SL and SPERMACETI (manufactured by NOF Corporation; "UNISTAR" is a registered trademark of the company), EXCEPARL SS and EXCEPARL MY-M (manufactured by Kao Corporation; "EXCEPARL" is a registered trademark of the company), EMALEX CC-18 and EMALEX CC-10 (manufactured by Nihon Emulsion Co., Ltd.; "EMALEX" is a registered trademark of the company), and AMREPS PC (manufactured by KOKYU ALCOHOL KOGYO CO., LTD.; "AMREPS" is a registered trademark of the company).

Since these commercially available products are often a mixture of two or more types, they may be separated and purified and contained in the ink as necessary. When the curable composition contains two or more selected from the ketone wax represented by Formula (G1) and the ester wax represented by Formula (G2), it is preferable to contain the ketone wax and the ester wax in combination.

The content of the gelling agent according to the present invention is preferably in the range of 0.5 to 5.0% by mass with respect to the total mass of the curable composition. When the content of the gelling agent is in the above range, the solubility of the gelling agent in the curable composition and the pinning effect are improved, and the water resistance of the cured product (cured film) is improved. From the above viewpoint, the content of the gelling agent in the curable composition is more preferably in the range of 0.5 to 2.5% by mass.

Moreover, from the following viewpoints, it is preferable that the gelling agent crystallizes in the curable composition at a temperature equal to or lower than the gelation temperature of the curable composition. The gelation temperature is the temperature at which the gelling agent undergoes a phase transition from sol to gel and the viscosity of the curable composition suddenly changes when the curable composition that has been solified or liquefied by heating is cooled. Specifically, the solified or liquefied curable composition is cooled while measuring the viscosity with a viscoelasticity measuring device (e.g., MCR300, manufactured by Physica Inc.), the temperature at which the viscosity abruptly increases may be taken as the gelation temperature of the curable composition.

The curable composition of the present invention contains a (meth)acrylic monomer as a main component, and if necessary, other photopolymerizable compound and a photopolymerization initiator, and further contains a thermosetting compound and a gelling agent. In the curable composition of the present invention, the photopolymerizable compound containing a (meth)acrylic monomer is reacted and cured (hereinafter, also referred to as "photocured") by irradiation with an active energy ray, and the thermosetting compound is reacted and cured (hereinafter, also referred to as "thermoset") by heating. The order of light curing and heat curing is not limited. For example, when the curable composition of the present invention is applied to an object to be coated, the applied coating solution is temporarily cured by photocuring by irradiation with active energy, and the coating solution is finally cured by thermosetting by heating, the incorporation of the gelling agent may suppress the wetting and spreading of the coating solution after the temporary curing, and a highly accurate pattern may be formed.

### <Optional component>

The curable composition may contain a colorant as an optional component. Further, a polymerization inhibitor, a surfactant, a curing accelerator, a coupling agent, and an ion scavenger may be included as other optional components to the extent that the effect of the present invention is obtained. As for other optional components, the curable composition of the present invention may contain only one type, or may contain two or more types.

### [Colorant]

The curable component of the present invention may further contain a colorant, as necessary. The colorant may be a dye or a pigment, but the pigment is preferred because it has good dispersibility with respect to components of the curable component and is excellent in weather resistance. The pigment is not particularly limited, and examples thereof include organic pigments or inorganic pigments having the following numbers described in Color Index.

Examples of red or magenta pigments include pigments selected from Pigment Reds 3, 5, 19, 22, 31, 38, 43, 48:1, 48:2, 48:3, 48:4, 48:5, 49:1, 53:1, 57:1, 57:2, 58:4, 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, and 257; Pigment Violets 3, 19, 23, 29, 30, 37, 50, and 88; and Pigment Oranges 13, 16, 20, and 36, or mixtures thereof.

Examples of blue or cyan pigments include pigments selected from Pigment Blues 1, 15, 15:1, 15:2, 15:3, 15:4, 15:6, 16, 17-1, 22, 27, 28, 29, 36, and 60, or mixtures thereof.

Examples of green pigments include pigments selected from Pigment Greens 7, 26, 36, and 50, or mixtures thereof.

Examples of yellow pigments include pigments selected from Pigment Yellows 1, 3, 12, 13, 14, 17, 34, 35, 37, 55, 74, 81, 83, 93, 94,95, 97, 108, 109, 110, 137, 138, 139, 153, 154, 155, 157, 166, 167, 168, 180, 185, and 193, or mixtures thereof.

Examples of black pigments include pigments selected from Pigment Blacks 7, 28, and 26, or mixtures thereof.

Specific examples of commercially available products of the pigment include Black Pigment (manufactured by Mikuni-Color Ltd.) CHROMOFINE YELLOWs 2080, 5900, 5930, AF-1300, and 2700L; CHROMOFINE ORANGEs 3700L and 6730; CHROMOFINE SCARLET 6750; CHROMOFINE MAGENTAs 6880, 6886, 6891N, 6790, and 6887; CHROMOFINE VIOLET RE; CHROMOFINE REDs 6820 and 6830; CHROMOFINE BLUEs HS-3, 5187, 5108, 5197, 5085N, SR-5020, 5026, 5050, 4920, 4927, 4937, 4824, 4933GN-EP, 4940, 4973, 5205, 5208, 5214, 5221, and 5000P; CHROMOFINE GREENs 2GN, 2GO, 2G-550D, 5310, 5370, and 6830; CHROMOFINE BLACK A-1103; SEIKAFAST YELLOWs 10GH, A-3, 2035, 2054, 2200, 2270, 2300, 2400(B), 2500, 2600, ZAY-260, 2700(B), and 2770; SEIKAFAST REDs 8040, C405(F), CA120, LR-116, 1531B, 8060R, 1547, ZAW-262, 1537B, GY, 4R-4016, 3820, 3891, and ZA-215; SEIKAFAST CARMINEs 6B1476T-7, 1483LT, 3840, and 3870; SEIKAFAST BORDEAUX 10B-430; SEIKALIGHT ROSE R40; SEIKALIGHT VIOLETs B800 and 7805; SEIKAFAST MAROON 460N; SEIKAFAST ORANGEs 900 and 2900; SEIKALIGHT BLUEs C718 and A612; CYANINE BLUEs 4933M, 4933GN-EP, 4940, and 4973 (manufactured by Dainichiseika Color & Chemicals Mfg. Co., Ltd.); KET Yellows 401, 402, 403, 404, 405, 406, 416, and 424; KET Orange 501; KET Reds 301, 302, 303, 304, 305, 306, 307, 308, 309, 310, 336, 337, 338, and 346; KET Blues 101, 102, 103, 104, 105, 106, 111, 118, and 124; KET Green 201 (manufactured by DIC Corporation), Colortex Yellows 301, 314, 315, 316, P-624, 314, U10GN, U3GN, UNN, UA-414, and U263; Finecol Yellows T-13 and T-05; Pigment Yellow 1705; Colortex Orange 202, Colortex Reds 101, 103, 115, 116, D3B, P-625, 102, H-1024, 105C, UFN, UCN, UBN, U3BN, URN, UGN, UG276, U456, U457, 105C, and USN; Colortex Maroon 601; Colortex Brown B610N; Colortex Violet 600; Pigment Red 122; Colortex Blues 516, 517, 518, 519, A818, P-908, and 510; Colortex Greens 402 and 403; Colortex Blacks 702 and U905 (manufactured by Sanyo Color Works. LTD.); Lionol Yellow 1405G; Lionol Blues FG7330, FG7350, FG7400G, FG7405G, ES, and ESP-S (manufactured by Toyo Ink SC Holdings Co., Ltd.); Toner Magenta E02; Permanent Rubin F6B; Toner Yellow HG; Permanent Yellow GG-02; Hostaperm Blue B2G (manufactured by Hoechst Industry Ltd.); Novoperm P-HG; Hostaperm Pink E; Hostaperm Blue B2G (manufactured by Clariant International Ltd.); and Carbon Blacks #2600, #2400, #2350, #2200, #1000, #990, #980, #970, #960, #950, #850, MCF88, #750, #650, MA600, MA7, MA8, MA11, MA100, MA100R, MA77, #52, #50, #47, #45, #45L, #40, #33, #32, #30, #25, #20, #10, #5, #44, and CF9 (manufactured by Mitsubishi Chemical Corporation).

The pigments may be dispersed, for example, with a ball mill, a sand mill, an Attritor, a roll mill, an agitator, a Henschel mixer, a colloid mill, an ultrasonic homogenizer, a pearl mill, a wet jet mill, or a paint shaker.

The pigment is preferably dispersed so that the volume average particle size of the pigment particles is preferably in the range of 0.08 to 0.5 µm and a maximum diameter of 0.3 to 10 µm, more preferably 0.3 to 3 µm. The dispersion of the pigment is adjusted by the selection of the pigment, the dispersant, and the dispersion medium, the dispersion conditions, the filtration conditions.

The curable composition of the present invention may further contain a dispersant in order to enhance the dispersibility of the pigment. Examples of the dispersant include carboxylic acid esters having a hydroxy group, salts of long chain polyamino amide and high molecular weight acid ester, salts of high molecular weight polycarboxylic acid, salts of long chain polyamino amide and polar acid ester, high molecular weight unsaturated acid esters, polymer copolymers, modified polyurethanes, modified polyacrylates, polyether ester type anionic surfactants, naphthalene sulfonic acid formalin condensate salts, aromatic sulfonic acid formalin condensate salts, polyoxyethylene alkyl phosphate esters, polyoxyethylene nonyl phenyl ethers, and stearyl amine acetates.

Examples of commercial dispersants include EFKA 7701 (manufactured by BASF Corp.), Solsperse series such as Solsperse 22000 (manufactured by Lubrizol Japan, Ltd.), and the PB series by Ajinomoto Fine Techno Co.

The curable composition of the present invention may further contain a dispersing aid if necessary. The dispersing aid may be selected according to the pigment.

The total amount of dispersant and dispersing aid is preferably in the range of 1 to 50% by mass based on the pigment.

The curable composition of the present invention may further contain a dispersion medium for dispersing the pigment, as necessary. Although the curable composition may contain a solvent as the dispersion medium, it is preferable to use a photopolymerizable compound as described above (especially a monomer having a low viscosity) as the dispersion medium in order to suppress the residual solvent in the formed image. When a photopolymerizable compound such as (meth)acrylic monomer is used as the dispersion medium, the amount of the dispersion medium is added to the content of the photopolymerizable compound such as (meth)acrylic monomer.

Examples of the dye include oil-soluble dyes. Examples of the oil-soluble dye include the following various dyes. Examples of magenta dyes include MS Magenta VP, MS Magenta HM-1450, MS Magenta HSo-147 (all manufactured by Mitsui Chemicals, Inc.), AIZEN SOT Red-1, AIZEN SOT Red-2, AIZEN SOT Red-3, AIZEN SOT Pink-1, and SPIRON Red GEH SPECIAL (all manufactured by Hodogaya Chemical Co., Ltd.); RESOLIN Red FB 200%, MACROLEX Red Violet R, and MACROLEX ROT5B (all manufactured by Bayer); KAYASET Red B, KAYASET Red 130, and KAYASET Red 802 (all manufactured by Nippon Kayaku Co., Ltd.); PHLOXIN, ROSE BENGAL, and ACID Red (all manufactured by Daiwa Dyestuff Mfg. Co., Ltd.); HSR-31 and DIARESIN Red K (all manufactured by Mitsubishi Chemical Corporation); and Oil Red (manufactured by BASF Japan Ltd.).

Examples of cyan dyes include MS Cyan HM-1238, MS Cyan HSo-16, Cyan HSo-144, and MS Cyan VPG (all manufactured by Mitsui Chemicals, Inc.); AIZEN SOT Blue-4 (manufactured by Hodogaya Chemical Co., Ltd.); RESOLIN BR. Blue BGLN 200%, MACROLEX Blue RR, CERES Blue GN, SIRIUS SUPRA TURQ. Blue Z-BGL, and SIRIUS SUPRA TURQ. Blue FB-LL 330% (all manufactured by Bayer); KAYASET Blue FR, KAYASET Blue N, KAYASET Blue 814, Turq. Blue GL-5200, and Light Blue BGL-5200 (all manufactured by Nippon Kayaku Co., Ltd.); DAIWA Blue 7000 and Oleosol Fast Blue GL (all manufactured by Daiwa Dyestuff Mfg. Co., Ltd.); DIARESIN Blue P (manufactured by Mitsubishi Chemical Corporation); and SUDAN Blue 670, NEOPEN Blue 808, and ZAPON Blue 806 (all manufactured by BASF Japan Ltd.).

Examples of yellow dyes include MS Yellow HSm-41, Yellow KX-7, and Yellow EX-27 (manufactured by Mitsui Chemicals, Inc.); AIZEN SOT Yellow-1, AIZEN SOT YelloW-3, and AIZEN SOT Yellow-6 (all manufactured by Hodogaya Chemical Co., Ltd.); MACROLEX Yellow 6G and MACROLEX FLUOR. Yellow 10GN (all manufactured by Bayer); KAYASET Yellow SF-G, KAYASET Yellow 2G, KAYASET Yellow A-G, and KAYASET Yellow E-G (all manufactured by Nippon Kayaku Co., Ltd.); DAIWA Yellow 330HB (manufactured by Daiwa Dyestuff Mfg. Co., Ltd.); HSY-68 (manufactured by Mitsubishi Chemical Corporation); and SUDAN Yellow 146 and NEOPEN Yellow 075 (all manufactured by BASF Japan Ltd.).

Examples of black dyes include MS Black VPC (Mitsui Chemicals, Inc.); AIZEN SOT Black-1 and AIZEN SOT Black-5 (all manufactured by Hodogaya Chemical Co., Ltd.); RESORIN Black GSN 200% and RESOLIN Black BS (all manufactured by Bayer Japan); KAYASET Black A-N (manufactured by Nippon Kayaku Co., Ltd.); DAIWA Black MSC (manufactured by Daiwa Dyestuff Mfg. Co., Ltd.); HSB-202 (manufactured by Mitsubishi Chemical Corporation); and NEPTUNE Black X60 and NEOPEN Black X58 (manufactured by BASF Japan Ltd.).

The curable composition of the present invention may contain one or more colorants and may be toned to a desired color. The content of the colorant is preferably in the range of 0.1 to 20% by mass, and more preferably in the range of 0.4 to 10% by mass based on the total amount of the curable composition.

### (Polymerization inhibitor)

Examples of the polymerization inhibitor include (alkyl)phenol, hydroquinone, catechol, resorcin, p-methoxyphenol, t-butylcatechol, t-butylhydroquinone, pyrogallol, 1,1-picrylhydrazyl, phenothiazine, p-benzoquinone, nitrosobenzene, 2,5-di-tert-butyl-p-benzoquinone, dithiobenzoyl disulfide, picric acid, cupferron, aluminum N-nitrosophenylhydroxylamine, tri-p-nitrophenylmethyl, N-(3-oxyanilino-1,3-dimethylbutylidene)aniline oxide, dibutylcresol, cyclohexanone oxime cresol, guaiacol, o-isopropylphenol, butyraldoxime, methyl ethyl ketoxime, and cyclohexanone oxime.

Examples of commercially available products of the polymerization inhibitor include Irgastab UV10 (manufactured by BASF Corp.) and Genorad 18 (manufactured by Rahn A.G.).

The amount of the polymerization inhibitor may be arbitrarily set as long as the effects of the present invention may be obtained. The amount of the polymerization inhibitor may be, for example, 0.001% by mass or more and less than 1.0% by mass based on the total mass of the curable composition.

### (Surfactant)

Examples of the surfactant include anionic surfactants such as dialkyl sulfosuccinates, alkylnaphthalene sulfonates, and fatty acid salts, nonionic surfactants such as polyoxyethylene alkyl ethers, polyoxyethylene alkyl allyl ethers, acetylene glycols, and polyoxyethylene/polyoxypropylene block copolymers, cationic surfactants such as alkylamine salts, and quaternary ammonium salts, and silicone-based or fluorine-based surfactants.

Examples of the silicone-based surfactant include polyether-modified polysiloxane compounds, specifically Tego rad 2250, manufactured by Evonik Co., Ltd., KF-351A, KF-352A, KF-642, and X-22-4272, manufactured by Shin-Etsu Chemical Co., Ltd., BYK 307, BYK 345, BYK 347, and BYK 348, manufactured by BYK-Chemie ("BYK" is a registered trademark of the company), and TSF 4452, manufactured by Momentary Performance Materials.

The fluorine-based surfactants are those in which some or all of hydrogen atoms bonding to the carbon of hydrophobic groups of ordinary surfactants are replaced with fluorine atoms. Examples of the fluorine-based surfactant include Megafac F manufactured by DIC Corporation ("Megafac" is a registered trademark of the company); Surflon manufactured by Asahi Glass Co., Ltd. ("Surflon" is a registered trademark of the company); Fluorad FC manufactured by 3M Company ("Fluorad" is a registered trademark of the company); Monflor manufactured by Imperial Chemical Industries; Zonyls manufactured by E. I. du Pont de Nemours and Company; Licowet VPF manufactured by Hoechst AG; and FTERGENT manufactured by NEOS COMPANY LIMITED ("FTERGENT" is a registered trademark of the company).

The amount of the surfactant may be arbitrarily set as long as the effects of the present invention may be obtained. The amount of the surfactant may be, for example, 0.001% by mass or more and less than 1.0% by mass based on the total mass of the curable composition.

### (Curing accelerator)

The curable composition of the present invention may contain a curing accelerator if necessary. As a curing accelerator, any agent that promotes thermal curing of the thermosetting compounds may be used without any particular restrictions.

Examples of the curing accelerator include imidazoles, dicyandiamide derivatives, dicarboxylic acid dihydrazide, triphenylphosphine, tetraphenylphosphonium tetraphenylborate, 2-ethyl-4-methylimidazole-tetraphenylborate, and 1,8-diazabicyclo[5.4.0]undecene-7-tetraphenylborate.

### (Coupling agent)

In the curable composition of the present invention, various coupling agents may be contained as necessary. The inclusion of coupling agents may improve adhesiveness to copper foil. Examples of various coupling agents include silane-based, titanium-based, and aluminum-based coupling agents.

### (Ion scavenger)

The curable composition of the present invention may contain an ion scavenger when needed. The inclusion of an ion scavenger has advantages such as adsorption of ionic impurities and improved insulation properties under conditions where the cured film absorbs moisture. Examples of the ion scavenger include inorganic ion adsorbents such as triazine thiol compounds, bisphenol-based reducing agents, zirconium compounds, and antimony bismuth-based magnesium aluminum compounds.

The amounts of the curing accelerator, coupling agent, and ion scavenger may be set arbitrarily within the range in which the effect of the invention may be obtained. The amount of these components may be, for example, 0.001% by mass or more to less than 1.0% by mass, respectively, based on the total mass of the curable composition.

From the viewpoint of curability, it is preferable to use the curable composition of the present invention as it is without dilution with a solvent for applications such as inks. In other words, the curable compositions of the present invention is preferably used without solvents. However, the curable composition may be used in the state of diluted solution by adding a solvent as necessary to adjust viscosity.

### [Physical properties of curable composition]

Physical properties of a cured product of the curable composition and physical properties of the curable composition will be described.

### <Relative permittivity of cured product>

The cured product of the curable composition of the present invention preferably has a relative permittivity at 1 MHz of less than 3.0. The relative permittivity at 1 MHz of the cured product is more preferably 2.95 or less, still more preferably 2.90 or less.

The cured product of the curable composition of the present invention has a relative permittivity at 10 GHz of less than 2.90. The relative permittivity at 10 GHz of the cured product is preferably 2.80 or less, and still more preferably 2.70 or less.

As a result, the curable composition of the present invention may be used, for example, for forming a solder resist film having a low dielectric constant capable of coping with 5G. In addition, when the curable composition of the present invention is used, for example, for forming a solder resist film, it is possible to apply to a high-performance device.

The relative permittivity of the cured product at 1 MHz and 10 GHz may be measured, for example, by the following method.

### (Method for measuring relative permittivity)

The cured product used for the measurement of the relative permittivity is prepared, for example, as follows. First, the curable composition is applied by inkjet to a substrate for preparing a cured product so as to form a solid pattern of 70 mm x 70 mm and 23 µm thick. The obtained coating layer is irradiated with an ultraviolet ray (395 nm) at a dose of 500 mJ/cm² using an LED lamp. The curable composition is photo-cured (precured), and then heat-cured (main-cured) for 60 minutes in an oven set at 150 °C. The cured product (film) is peeled off from the substrate for producing the cured product, and cut into a measurement sample having an approximately 5 cm square.

### (Relative permittivity at 1 MHz)

The relative permittivity at 1 MHz is measured by, for example, an LCR meter method, in which a tin foil having a main electrode-diameter of 1.8 cm is attached to the measurement sample obtained as described above to form electrodes, and then the relative permittivity is measured. The measurement is performed in a test atmosphere at room temperature (23 ± 2 °C, 50 ± 5 %RH), and the thicknesses are measured with a micrometer and averaged at five points. As measurement devices, for example, an LCR meter (HP4284A, manufactured by Agilent Technologies Inc.), a thermostatic bath; T0-19, (manufactured by Ando Electric Co., Ltd.), and solid electrodes; SE-70, (manufactured by Ando Electric Co., Ltd.) may be used.

### (Relative permittivity at 10 GHz)

The relative permittivity at 10 GHz is measured by a cavity resonator method, in which the measurement sample obtained above is used as it is. The measurement is performed in a test atmosphere of room temperature (23 ± 2 °C, 50 ± 5 %RH), and the thicknesses are measured with a micrometer and averaged at five points. As measurement devices, Synthesized Sweeper 8340B (manufactured by YHP Inc.), Network Analyzer 8510B (manufactured by YHP Inc.), cylindrical cavity resonator: near TE mode 10 GHz (material: Cu, internal mirror finish), and semi-rigid cable for signal transmission may be used.

### (Viscosity and phase transition point of curable composition)

The curable composition of the present invention has preferably a viscosity at 25 °C in the range of 1 to 1 x 10⁴ Pa·s. For example, when the curable composition is used as an inkjet ink, the ink is sufficiently gelled when the ink lands and the temperature is lowered to normal temperature, which is preferable in that the pinning property is improved. In addition, when used as an inkjet ink, from the viewpoint of further enhancing ejection properties from an inkjet head, the viscosity of the curable composition of the present invention at 80 °C is preferably in the range of 3 to 20 mPa·s, and more preferably in the range of 7 to 9 mPa·s.

The curable composition of the present invention preferably has a phase transition point in the range of 40 °C or higher and lower than 100 °C. When the phase transition point is 40 °C or higher, for example, when the curable composition is used as an inkjet ink, the ink (curable composition) rapidly gels after landing on a recording medium. Therefore, it is possible to form high-definition images and patterns. Further, when the phase transition point is less than 100 °C, the curable composition has good handling property and shows high ejection stability. Similarly, when the curable composition is used as an inkjet ink, the ink (curable composition) may be discharged at a lower temperature. From the viewpoint of reducing the load on the image forming apparatus, the phase transition point of the curable composition of the present invention is more preferably in the range of 40 to 60 °C.

The viscosity at 25 °C, the viscosity at 80 °C, and the phase transition point of the curable composition of the present invention are values obtained by the following method using a viscoelasticity measuring apparatus.

The viscosity at 25 °C, the viscosity at 80 °C, and the phase transition point of the present invention are measured at a shear rate of 1000 (1/s) using a viscoelasticity measuring device, for example, MCR300 (manufactured by Physica Inc.). Here, the phase transition point is a temperature at which the complex viscosity becomes 1 Pa in a viscoelastic curve obtained by changing the temperature at a cooling rate of 0.1 °C/s, a strain of 5%, an angular frequency of 10 radian/s, and a cooling rate of 0.1 °C/s.

When the curable composition is used as an inkjet ink, from the viewpoint of further improving discharge ability from an inkjet head, it is preferable that the average dispersion particle size of the colorant particles according to the present invention is in the range of 50 to 150 nm, the maximum particle size is in the range of 300 to 1000 nm, and the more preferable average dispersion particle size is in the range of 80 to 130 nm.

The average dispersed particle size of the pigment particles in the present invention means a value obtained by a dynamic light scattering method using Zetasizer Nano ZSP, manufactured by Malvern Instruments Ltd. Since an ink containing a colorant has a high concentration and light does not pass through this measurement device, the measurement is performed after diluting the ink (curable composition) by a factor of 200. The measurement temperature is normal temperature (25 °C).

The curable composition of the present invention is used by being applied to an object to be coated and cured. The method for applying the curable composition to the object to be coated is not particularly limited, and a known coating method may be applied, but as described above, when the curable composition is applied by an inkjet method, the effect of the present invention may be more exhibited, which is preferable.

As described above, the curable composition of the present invention is cured by a combination of photocuring and thermal curing. The order of the photocuring and the thermal curing is not particularly limited, but a method of performing the thermal curing after the photocuring is preferable from the viewpoint of workability. The cured product of the curable composition of the present invention has a relative permittivity at 10 GHz of less than 2.90. In addition, the penetration of oxygen or moisture from the outside into the cured product may be suppressed by the action of the gelling agent.

In view of the above properties, it is particularly advantageous to use the curable composition of the present invention in a solder resist ink. In addition, the curable composition of the present invention may be used not only as an ink for forming a solder resist pattern, it may be also used as an adhesive, a sealant, and a circuit protective agent for an electronic component.

### [Solder resist ink]

The solder resist ink of the present invention is characterized in that it contains the curable composition of the present invention. The solder resist ink may contain only the curable composition of the present invention, or may contain other components other than the curable composition as necessary. Other components include the solvents mentioned above. It is preferred that the solder resist ink of the present invention is composed of the curable composition of the present invention.

The solder resist ink of the present invention is an ink for forming a solder resist film used for a printed circuit board. By containing the curable composition of the present invention, when a solder resist pattern (solder resist film) is formed, the solder resist ink of the present invention may prevent penetration of oxygen or moisture into the solder resist film by a card house structure formed by the gelling agent, and as a result, the generation of polar groups is reduced, and thus a low dielectric constant may be achieved. In addition, in the printed circuit board, the adhesiveness of the interface between the circuit pattern (conductor pattern), for example, copper wiring, and the solder resist film is improved, and the migration of the conductor, for example, copper, is prevented, so that the deterioration of the insulation property may be suppressed.

### [Printed circuit board]

A printed circuit board of the present invention includes a substrate, a circuit pattern provided on a surface of the substrate, and a solder resist film provided on the circuit pattern, wherein the solder resist film is formed using the solder resist ink of the present invention.

The configuration of the printed circuit board of the present invention other than the solder resist film may be the same as that of a known printed circuit board.

For example, the substrate in the printed circuit board is not particularly limited, and a substrate made of a known material, for example, an insulating material such as paper phenol, paper epoxy, glass cloth epoxy, glass polyimide, glass cloth/non-woven cloth epoxy, glass cloth/paper epoxy, synthetic fiber epoxy, fluorine, polyethylene, polyphenylene oxide (PPO), cyanate ester, polyimide, polyethylene terephthalate (PET), glass, or ceramic may be used.

The printed circuit board has a circuit pattern (conductor pattern) on the surface of the board according to a design, and a solder resist film on the circuit pattern, leaving only the contact points that are electrically connected to the outside by soldering, for example. The solder resist film may be patterned and formed according to the design of the printed circuit board. The thickness of the solder resist film depends on the type and application of the printed circuit board, for example, it may be 10 to 60 µm, and 15 to 40 µm is preferred.

In the printed circuit board, the wiring conductor may be formed as a circuit pattern (conductor pattern) on one surface or both surfaces of the board. It may be a multilayer board or a build-up board in which the wiring conductor is formed not only on the surface of the board but also inside the board. In the printed circuit board of the present invention, the circuit pattern (conductor pattern) is preferably composed of copper wiring. For example, as the substrate of the printed circuit board, a material such as a copper-clad laminate for a high-frequency circuit may be used, and a copper-clad laminate of any grade (FR-4) may be used. In such a substrate, the copper wiring is formed by processing a copper layer (copper foil) on the surface by etching.

In the printed circuit board of the present invention, since the solder resist film is formed using the solder resist ink of the present invention, the solder resist film has a relative permittivity of less than 2.90 at 10 GHz and is excellent in adhesiveness and heat resistance. In order to further improve the adhesiveness in forming the solder resist film on the copper wiring, the copper wiring preferably has a surface roughness Ra in the range of 0. 1 to 2.0 µm. When the surface roughness Ra is within the above range, the adhesiveness of the solder resist film to the copper wiring is improved when the solder resist ink is applied.

In order to adjust the surface roughness Ra of the conductor wiring, for example, it is preferable to perform a roughening treatment or a pretreatment for preventing bleeding on a conductor layer as a circuit pattern (conductor pattern) such as copper wiring. Examples of the method of the roughening treatment include a treatment (physical polishing treatment) of forming a rough surface by forming unevenness on the surface of the conductor layer by means such as buffing or scrubbing, and a chemical polishing treatment using a chemical polishing agent such as a copper chloride-based, a persulfate-based, a sulfuric acid / hydrogen peroxide-based, a formic acid-based, or an organic acid-based chemical polishing agent.

For the above pretreatment, chemical polishing or adhesion-enhancing treatment is preferable from the viewpoint of improving adhesiveness, and organic acid-based treatment is even more preferable for chemical polishing. Specific examples of the chemical polishing treatment include treatment using MultiPrep 200 from MacDermid, Inc. as a copper chloride-based treatment, Microclean ME-301 and PR-820 from MacDermid, Inc. as a persulfate-based treatment, GB1000F /1400, G200, GB3100, GB4300 from Shikoku Chemicals Corporation, Multibond 100, Multibond 150, Multibond MP, Metex G-5, Metex G-6, ME-501, ME-602, ME-605, ME-709 from MacDermid, Inc., BTH-2066 from BOARDTEC, CPE-900, EMR-5000 and EMR-7000 from Mitsubishi Gas Chemical Co., Inc., organic acids including CZ8100, CZ8101, CZ8201 from MEC, and BTH-2085 from BOARDTEC. Examples of the treatment for improving adhesiveness include the GT process of MEC Co., Ltd. and the GliCAP treatment of Shikoku Kasei Co., Ltd.

From the viewpoint of improving adhesiveness, a sulfuric acid/hydrogen peroxide system and an organic acid system are preferable, and an organic acid system is more preferable.

The surface roughness Ra of the circuit pattern (conductive pattern) roughened by the pre-treatment is preferably 0.1 to 2.0 µm, more preferably 0.1 to 1.5 µm, still more preferably 0.2 to 1.3 µm, and most preferably 0.3 to 1.1 µm. When the surface roughness Ra is 0.1 µ m or more, the adhesiveness is further improved, and when the surface roughness Ra is 2.0 µm or less, the bleeding and the transmission loss at 10 GHz are further suppressed.

The thickness of the circuit pattern (conductor pattern) such as copper wiring roughened by the pretreatment agent is preferably 0.1 to 3.0 µm, more preferably 0.3 to 2.0 µ m, and still more preferably 0.5 to 1.5 µm. When the roughened thickness is 0.1 µm or more, the adhesiveness is improved by an anchor effect, and when the roughened thickness is 3.0 µm or less, the conductor such as copper is not roughened more than necessary, and thus the adhesiveness is improved.

The surface roughness Ra may be controlled by adjusting conditions such as the type of the pretreatment agent and the temperature and time of the treatment. The surface roughness Ra is an arithmetic average roughness measured based on JIS B 0601. Specifically, the surface roughness Ra may be measured by a scanning probe microscope (SPM), a non-contact interference microscope (WYKO), a laser microscope, and a surface roughness device(contact needle method).

### [Method for forming solder resist film]

A method of forming a solder resist film using the solder resist ink (hereinafter, also simply referred to as an "ink") of the present invention preferably includes the steps of: (1) ejecting the ink of the present invention from a nozzle of an inkjet head to land the ink on a circuit pattern of a printed circuit board on which the circuit pattern is formed; (2) irradiating the landed ink with an active energy ray to photocure (temporarily cure) the ink; and (3) heating the ink to thermally cure (fully cure) the ink.

<Step (1)>

In the step (1), droplets of the ink of the present invention are discharged from an inkjet head and landed on a region on which a solder resist film is to be formed, including a circuit pattern on a printed circuit board, to perform patterning. The method of discharging from the inkjet head may be either an on-demand method or a continuous method.

The on-demand type inkjet head may be any of an electromechanical conversion type such as a single cavity type, a double cavity type, a bender type, a piston type, a shear-mode type, and a sheared wall type, and an electrothermal conversion type such as a thermal inkjet type and a Bubble Jet (registered trademark) (Bubble Jet is a registered trademark of Canon Inc.).

Ejection stability may be improved by ejecting the ink droplets from the inkjet head in a heated state. The temperature of the ink when ejected is preferably in the range of 40 to 100 °C, and more preferably in the range of 40 to 90 °C in order to further improve the ejection stability. In particular, the ejection is preferably performed at an ink temperature at which the viscosity of the ink is in the range of 7 to 15 mPa·s, and more preferably in the range of 8 to 13 mPa·s.

In the sol-gel phase transition type ink, in order to enhance the ejection property of the ink from the inkjet head, the temperature of the ink when the ink is filled in the inkjet head is preferably set to (gelation temperature (phase transition point) + 10) °C to (gelation temperature (phase transition point) + 30) °C. When the temperature of the ink in the inkjet head is lower than (gelling temperature + 10) °C, the ink gels in the inkjet head or on the surface of the nozzle, and the ejection property of the ink tends to decrease. On the other hand, when the temperature of the ink in the inkjet head exceeds (gelation temperature + 30) °C, the temperature of the ink becomes too high, and thus the ink components may be deteriorated.

The method of heating the ink is not restricted. For example, at least one of the ink supply system such as ink tanks, supply pipes, and front chamber ink tanks immediately in front of the head that make up the head carriage, piping with filters, and piezo heads may be heated by a panel heater, a ribbon heater, or warm water.

The amount of droplets of the ink at the time of ejection is preferably in the range of 2 to 20 pL from the viewpoint of ensuring the efficiency of the operation, the thinness of the resulting solder resist film capable of protecting the circuit pattern, and the fine line reproducibility of the circuit pattern.

### <Step (2)>

In the step (2), the ink landed in the step (1) is irradiated with an active energy ray to temporarily cure the ink. The active energy rays may be selected from, for example, an electron beam, ultraviolet rays, α-rays, γ-rays, and X-rays, and is preferably ultraviolet rays.

The irradiation with ultraviolet rays may be performed, for example, using a water-cooled LED manufactured by Phoseon Technology under the condition of wavelength of 395 nm. By using an LED as a light source, it is possible to suppress poor hardening of the ink due to melting of the ink by radiant heat of the light source.

In the ultraviolet irradiation, the peak irradiance of ultraviolet rays having a wavelength in the range of 370 to 410 nm on the surfaces of the ink coating films is preferably 0.5 to 10 W/cm², more preferably 1 to 5 W/cm². From the viewpoint of preventing the ink from being irradiated with radiant heat, the amount of light with which the ink coating film is irradiated is preferably less than 1000 mJ/cm². The irradiation with the active energy ray is preferably performed within 0.001 to 300 seconds after the landing of the ink, and is more preferably performed within 0.001 to 60 seconds in order to form a highly precise solder resist film.

### <Step (3)>

In the step (3), after the temporary curing in the step (2), the ink coating film is further heated to be subjected to main curing. As a heating method, for example, the ink coating film is preferably put in an oven set in the range of 110 to 180 °C for 10 to 60 minutes.

### Examples

Hereinafter, the present invention will be specifically described with reference to Examples, but the present invention is not limited thereto. In the following Examples, unless otherwise specified, operations were performed at room temperature (25 °C). Unless otherwise specified, "%" and "part" mean "% by mass" and "part by mass", respectively.

### <Components of curable composition>

Commercially available products or compounds shown in Table I were used as a (meth)acrylic monomer, a thermosetting compound, a photopolymerization initiator, and a gelling agent which are the constituent compounds of the curable compositions of the following Examples and Comparative Examples. For the (meth)acrylic monomers, the molecular weight, ClogP, and classification are also listed.

**Table I**

| Component | No. | Product name | Company name |
|---|---|---|---|
| | A-1 | FA-513AS | Hitachi Chemical Co., Ltd. |
| | A-2 | M1602 | Miwon |
| | A-3 | M360 | Miwon |
| (Meth)acrylic monomer | A-4 | M262 | Miwon |
| | A-5 | M222 | Miwon |
| | A-6 | NK Ester DOD-N | SHIN-NAKAMURA CHEMICAL Co., Ltd. |
| | A-7 | NK Ester A-400 | SHIN-NAKAMURA CHEMICAL Co., Ltd. |
| | A-8 | M290 | Miwon |
| | A-9 | M500 | Miwon |
| | B-1 | Karenz MOI | Showa Denko K.K. |
| | B-2 | Karenz MOI-BP | Showa Denko K.K. |
| | B-3 | Karenz MOI-BM | Showa Denko K.K. |
| | B-4 | TrixeneBI7961 | LANXESS |
| Thermosetting compound | B-5 | TrixeneBI7982 | LANXESS |
| | B-6 | TrixeneBI7992 | LANXESS |
| | B-7 | PU5211 | LeesonPolyurethanes |
| | B-8 | VESTANATB1186A | Evonik |
| | B-9 | EA-1010N | SHIN-NAKAMURA CHEMICAL Co., Ltd. |
| | B-10 | YX-4000 | Mitsubishi Chemical Corporation |
| | B-11 | BMI-80 | K-I Chemical Industry Co., Ltd. |
| | B-12 | BMI-4000 | Daiwa Kasei Industry Co., Ltd. |
| Photopolymerization initiator | C-1 | Omnirad TPO H | IGM |
| | C-2 | Omnirad ITX | IGM |
| Gelling agent | D-1 | Ketone wax represented by Formula (G1) | |
| | D-2 | Ester wax represented by Formula (G2) | |

**Table I Continued**

| Component | No. | Compound name | Molecular weight | ClogP | Type |
|---|---|---|---|---|---|
| | A-1 | Dicyclopentanyl acrylate | 206 | 3.1 | Other |
| | A-2 | Nonylphenol 2PO modified acrylate | 390 | 7.6 | (A2) |
| | A-3 | Trimethylolpropane PO modified triacrylate | 470 | 4.0-5.0 | (A1) |
| (Meth)acrylic monomer | A-4 | Tricyclodecane dimethanol diacrylate | 304 | 4.7 | (A1) |
| | A-5 | Dipropylene glycol diacrylate | 242 | 2.0 | (A2) |
| | A-6 | 1,10-Decanediol dimethacrylate | 310 | 5.8 | (A1) |
| | A-7 | Polyethylene glycol diacrylate (n = 9) | 508 | 0.2-0.5 | (A2) |
| | A-8 | Bisphenol F 4EO modified diacrylate | 499 | 5.0-5.2 | (A1) |
| | A-9 | Dipentaerythritol pentaacrylate | 524 | 3.8 | (A1) |
| | B-1 | 2-Methacryloyloxyethyl isocyanate | | | |
| | B-2 | 2-[(3,5-Dimethylpyrazolyl)carbonylamino]ethyl methacrylate | | | |
| | B-3 | 2-(0-[1' -Methylpropylideneamino]carboxyamino)ethyl methacrylate | | | |
| | B-4 | Blocked isocyanate | | | |
| Thermosetting compound | B-5 | Blocked isocyanate | | | |
| | B-6 | Blocked isocyanate | | | |
| | B-7 | Blocked isocyanate | | | |
| | B-8 | Blocked isocyanate | | | |
| | B-9 | Glycidyl ether-containing epoxy acrylate bisphenol A skeleton | | | |
| | B-10 | Biphenyl type epoxy | | | |
| | B-11 | 2,2'-bis-[4-(4-Maleimidophenoxy)phenyl]propane | | | |
| | B-12 | Bisphenol A diphenyl ether bismaleimide | | | |
| Photopolymerization initiator | C-1 | 2,4,6-Trimethylbenzoyldiphenylphosphine oxide | | | |
| | C-2 | 2-Isopropylthioxanthone | | | |
| Gelling agent | D-1 | Distearyl ketone | | | |
| | D-2 | Behenyl behenate | | | |

### <Preparation of colorant dispersion>

Pigment dispersions formulated in the curable compositions were prepared as follows and used.

(E-1: Preparation of yellow pigment dispersion) The following dispersants 1 and 2 and the dispersion medium were placed in stainless steel beakers, heated and stirred for 55 minutes while heating on a hotplate at 62 °C. After cooling to room temperature, the following pigments were added thereto, and the mixture was placed in a glass bottle together with a 200 g of zirconia beads having diameters of 0.5 mm, and the bottle was sealed tightly. After dispersing the mixture with a paint shaker until the desired particle size was achieved, the zirconia beads were removed.
Dispersant 1: EFKA 7701 (manufactured by BASF Corp.): 6.2 parts by mass
Dispersant 2: Solsperse 22000 (manufactured by Lubrizol Japan, Ltd.): 0.5 parts by mass
Dispersion medium: Dipropylene glycol diacrylate (containing 0.2% UV-10): 82.3 mass parts by mass
Pigment: PY185 (manufactured by BASF Corp., Paliotol Yellow D1155): 13.8 parts by mass

### (E-2: Preparation of cyan pigment dispersion)

The cyan pigment dispersion was prepared in the same manner as described in the above preparation of yellow pigment dispersion, except that a dispersant, a dispersion medium and a pigment were changed as shown below.
Dispersant: EFKA 7701 (manufactured by BASF Corp.): 6.7 parts by mass
Dispersion medium: Dipropylene glycol diacrylate (containing 0.2% UV-10): 72 parts by mass
Pigment: PB 15:4 (Dainichiseika, Chromo-fine blue 6332JC): 21 parts by mass

### [Preparation of curable composition (inkjet ink)]

Components were mixed in accordance with the ink compositions (parts by mass) shown in Tables II to IV below, and the mixture were filtered through a Teflon (registered trademark) 3 µm membrane filter manufactured by ADVANTEC Co., Ltd. to obtain curable compositions (inkjet inks, hereinafter also simply referred to as "inks") AA-1 to AA-16, AB-1 to AB-6 (Table II and Table III), and BB-1 to BB-11 (Table IV).

In Tables II through IV, the amount of dipropylene glycol diacrylate contained by the pigment dispersions E-1 and E-2 blended and the amount of M222 (dipropylene glycol diacrylate) formulated as (meth)acrylic monomer A-5 were combined. The total amount (parts by mass) of dipropylene glycol diacrylate is listed in the column of (meth)acrylic monomer A-5. In addition, in the column of pigment dispersion, the amount blended as pigment dispersions E-1 and E-2, i.e., the amount containing dipropylene glycol diacrylate as a dispersion medium, is described as it is.

Specifically, in ink AA-1 in Table II, 54 parts by mass and 34 parts by mass of the (meth)acrylic monomers A-9 and A-8, respectively, were used as the (meth)acrylic monomer, and the pigment dispersions E-1 and E-2 each were used in an amount of 1 part by mass. However, since the pigment dispersions E-1 and E-2 contain dipropylene glycol diacrylate, the amount of dipropylene glycol diacrylate contained in each of the pigment dispersions E-1 and E-2 at the above-described ratio in 1 part by mass of each of the pigment dispersions E-1 and E-2 was calculated, and 1.5 parts by mass of the total amount was described in the column of the (meth)acrylic monomer A-5 in Table II. The other inks in Tables II to IV were treated in the same manner.

In all of the inks shown in Tables II through IV, pigment dispersions E-1 and E-2 are used in 1.5 part by mass each. Therefore, the amount of (meth)acrylic monomer A-5 derived from the pigment dispersion is 1.5 parts by mass. In Table IV, there is an ink in which the amount of (meth)acrylic monomer A-5 exceeds 1.5 parts by mass, in such ink, M222 (dipropylene glycol diacrylate) in an amount obtained by subtracting 1.5 parts by mass from the amount of the (meth)acrylic monomer A-5 shown in Table IV was used at the time of preparation of the ink. In Tables II through IV, a blank column indicates that the amount of the component concerned is "0" part by mass.

Tables II through IV also show the percentages of (meth)acrylic monomers (A1), (A2), and others in (meth)acrylic monomers [% by mass].

### [Physical properties of ink]

### (Viscosity and Phase transition point)

The viscosity at 25 °C and the phase transition point of each of the obtained inks AA-1 to AA-16, AB-1 to AB-6, and BB-1 to BB-11 were measured by the methods described above.

The viscosity of each of the inks of the present invention at 25 °C is 1 to 1 x 10⁴ Pa·s, whereas the viscosity of each of the inks without a gelling agent of Comparative Examples was less than 1 Pa·s. The gel-phase transition temperature of each of the inks of the present invention was a temperature of 40 to 100 °C, but the gel-phase transition phenomenon was not observed in the inks of Comparative Examples containing no gelling agent.

### (Relative permittivity of ink cured product)

Using each of the obtained inks AA-1 to AA-16, AB-1 to AB-6, and BB-1 to BB-11, a solid pattern was printed on a polypropylene film with an inkjet recording apparatus described below and cured to produce a measurement sample of a cured product (film).

To be specific, the ink is applied onto the propylene film by inkjet so as to form a solid pattern of 70 mm x 70 mm and 23 µm thick. The obtained ink layer was cured with an LED lamp manufactured by Phoseon Technology (395 nm, 8 W/cm², water cooled unit) emitting ultraviolet (395 nm) light in the range of 500 mJ/cm². Thereafter, the cured product (film) was peeled off from the propylene film and thermally cured (fully cured) for 60 minutes in an oven set at 150 °C. A measurement sample was cut out at an approximately 5 cm square, and the relative permittivity at 1 MHz and 10 GHz were measured by the method described above. The results are also shown in Tables II to IV.

### [Evaluation 1]

The adhesiveness to the copper layer of the copper-clad laminate and the heat resistance of the cured film of the ink were evaluated by the following method.

### (1) Preparation of evaluation laminated sample

### <Treatment of copper-clad laminate>

A copper-clad laminate (FR-4; 1.6 mm thick, 150 mm x 95 mm in size) for a printed wiring board was treated with a treatment liquid CZ-8100 (MEC Co., Ltd.) to prepare a pretreated copper-clad laminate having a copper layer with a surface roughness Ra of 1.5 µm. The surface roughness Ra is an arithmetic mean roughness measured with a laser microscope.

### <Pattern formation by inkjet>

Each of the inkjet inks prepared above was loaded into an inkjet recording apparatus having an inkjet recording head equipped with a piezo type inkjet nozzle. Using this apparatus, a pattern was formed on the copper-clad laminate for a printed wiring board (FR-4, 1.6 mm thick, 150 mm x 95 mm in size) which was performed the above-described copper pretreatment.

The ink supply system includes an ink tank, an ink channel, a sub ink tank immediately before an inkjet recording head, a pipe with a metallic filter, and a piezo head. The ink was heated to 80 °C from the ink tank to the head portion. A heater was also incorporated in the piezo head, and the ink in the piezo head was heated to 75 °C. As the piezo head, KM1800i SHC manufactured by Konica Minolta, Inc. was used.

Using this inkjet apparatus, a voltage was applied so that the amount of droplets was 3.5 pl dots, and an ink layer of a 70 mm x 70 mm solid pattern and a comb-shaped pattern having a line and space of 100 µm were formed on the substrate so as to be 23 µm thick, respectively, and then the ink layer was temporarily cured by irradiating with an LED lamp (395 nm, 8W/cm², water cooled unit) at 500 mJ/cm². The ink layer was then placed in an oven set at 150 °C for 60 minutes for final curing, and a laminate sample with a cured film pattern formed on the above pretreated copper layer of the copper-clad laminate was obtained.

### (2) Evaluation of laminated samples

### <Substrate adhesiveness>

With respect to the laminated sample with the solid pattern, the cured film was cut in a grid pattern in accordance with the cross-cut method of JIS K5600, and an adhesive tape was attached and peeled off to observe the peeled state of the cured film, and the adhesion residual rate was determined by the following method and evaluated according to the following criteria.

### (Criteria)

5: Adhesion residual ratio of 100%
4: Adhesion residual ratio of 80% or more and less than 100%
3: Adhesion residual ratio of 60% or more and less than 80%
2: Adhesion residual ratio of 50% or more and less than 60%
1: Adhesion residual ratio of less than 50%

### <Solder heat resistance>

The laminated sample with the solid pattern was immersed in a solder bath at 260 °C for 10 seconds three times, and then the above-described evaluation of the adhesion residual ratio was performed, and the peeled state of the cured film was observed.

**Table II**

| Curable composition No. | | | | AA-1 | AA-2 | AA-3 | AA-4 | AA-5 |
|---|---|---|---|---|---|---|---|---|
| | Component | Type | No. | | | | | |
| | (Meth)acrylic monomer | (A1) | A-3 | 54.0 | 54.0 | 54.0 | 54.0 | 54.0 |
| | | | A-8 | 34.0 | 34.0 | 34.0 | 34.0 | 34.0 |
| | | (A2) | A-5 | 1.5 | 1.5 | 1.5 | 1.5 | 1.5 |
| | | Total | | 89.5 | 89.5 | 89.5 | 89.5 | 89.5 |
| | | B-1 | | 5.0 | | | | |
| | | B-2 | | | 5.0 | | | |
| | | B-3 | | | | 5.0 | | |
| | | B-4 | | | | | 5.0 | |
| | | B-5 | | | | | | 5.0 |
| Composition (parts by mass) | Thermosetting compound | B-6 | | | | | | |
| | | B-7 | | | | | | |
| | | B-8 | | | | | | |
| | | B-9 | | | | | | |
| | | B-10 | | | | | | |
| | | B-11 | | | | | | |
| | | B-12 | | | | | | |
| | Photopolymerization initiator | C-1 | | 2.5 | 2.5 | 2.5 | 2.5 | 2.5 |
| | | C-2 | | 0.5 | 0.5 | 0.5 | 0.5 | 0.5 |
| | Gelling agent | D-1 | | 2.0 | 2.0 | 2.0 | 2.0 | 2.0 |
| | Pigment dispersion (amount including A-5) | E-1 | | 1.0 | 1.0 | 1.0 | 1.0 | 1.0 |
| | | E-2 | | 1.0 | 1.0 | 1.0 | 1.0 | 1.0 |
| Physical property | Cured product | Relative permittivity; 1 MHz | | 2.93 | 2.89 | 2.87 | 2.85 | 2.88 |
| | | Relative permittivity; 10 GHz | | 2.71 | 2.69 | 2.68 | 2.65 | 2.68 |
| Evaluation | Metal adhesiveness | | | 3 | 4 | 4 | 4 | 4 |
| | Heat resistance | | | 4 | 4 | 4 | 4 | 4 |
| Remarks | | | | Present Invention | Present Invention | Present Invention | Present Invention | Present Invention |

**Table II Continued**

| Curable composition No. | | | | AA-6 | AA-7 | AA-8 | AA-9 | AA-10 | AA-11 |
|---|---|---|---|---|---|---|---|---|---|
| | Component | Type | No. | | | | | | |
| | (Meth)acrylic monomer | (A1) | A-3 | 54.0 | 54.0 | 54.0 | 54.0 | 54.0 | 54.0 |
| | | | A-8 | 34.0 | 34.0 | 34.0 | 34.0 | 34.0 | 34.0 |
| | | (A2) | A-5 | 1.5 | 1.5 | 1.5 | 1.5 | 1.5 | 1.5 |
| | | Total | | 89.5 | 89.5 | 89.5 | 89.5 | 89.5 | 89.5 |
| | | B-1 | | | | | | | |
| | | B-2 | | | | | | | |
| | | B-3 | | | | | | | |
| | | B-4 | | | | | | | |
| Composition (parts by mass) | | B-5 | | | | | | | |
| | Thermosetting compound | B-6 | | 5.0 | | | | | |
| | | B-7 | | | 5.0 | | | | |
| | | B-8 | | | | 5.0 | | | |
| | | B-9 | | | | | 5.0 | | |
| | | B-10 | | | | | | 5.0 | |
| | | B-11 | | | | | | | 5.0 |
| | | B-12 | | | | | | | |
| | Photopolymerization initiator | C-1 | | 2.5 | 2.5 | 2.5 | 2.5 | 2.5 | 2.5 |
| | | C-2 | | 0.5 | 0.5 | 0.5 | 0.5 | 0.5 | 0.5 |
| | Gelling agent | D-1 | | 2.0 | 2.0 | 2.0 | 2.0 | 2.0 | 2.0 |
| | Pigment dispersion (amount including A-5) | E-1 | | 1.0 | 1.0 | 1.0 | 1.0 | 1.0 | 1.0 |
| | | E-2 | | 1.0 | 1.0 | 1.0 | 1.0 | 1.0 | 1.0 |
| Physical property | Cured product | Relative permittivity; 1 MHz | | 2.89 | 2.87 | 2.89 | 2.92 | 2.93 | 2.95 |
| | | Relative permittivity; 10 GHz | | 2.69 | 2.67 | 2.68 | 2.73 | 2.74 | 2.74 |
| Evaluation | Metal adhesiveness | | | 4 | 4 | 4 | 3 | 3 | 3 |
| | Heat resistance | | | 4 | 4 | 4 | 3 | 3 | 3 |
| Remarks | | | | Present Invention | Present Invention | Present Invention | Present Invention | Present Invention | Present Invention |

**Table III**

| Curable composition No. | | | | AA-12 | AA-13 | AA-14 | AA-15 | AA-16 |
|---|---|---|---|---|---|---|---|---|
| | Component | Type | No. | | | | | |
| | (Meth)acrylic monomer | (A1) | A-3 | 54.0 | 54.0 | 54.0 | 54.0 | 54.0 |
| | | | A-8 | 34.0 | 38.0 | 24.0 | 38.2 | 23.0 |
| | | (A2) | A-5 | 1.5 | 1.5 | 1.5 | 1.5 | 1.5 |
| | | Total | | 89.5 | 93.5 | 79.5 | 93.7 | 78.5 |
| | | B-1 | | | | | | |
| | | B-2 | | | | | | |
| | | B-3 | | | | | | |
| | | B-4 | | | 1.0 | 15.0 | 0.8 | 16.0 |
| Composition (parts by mass) | | B-5 | | | | | | |
| | Thermosetting compound | B-6 | | | | | | |
| | | B-7 | | | | | | |
| | | B-8 | | | | | | |
| | | B-9 | | | | | | |
| | | B-10 | | | | | | |
| | | B-11 | | | | | | |
| | | B-12 | | 5.0 | | | | |
| | Photopolymerization initiator | C-1 | | 2.5 | 2.5 | 2.5 | 2.5 | 2.5 |
| | | C-2 | | 0.5 | 0.5 | 0.5 | 0.5 | 0.5 |
| | Gelling agent | D-1 | | 2.0 | 2.0 | 2.0 | 2.0 | 2.0 |
| | Pigment dispersion (amount including A-5) | E-1 | | 1.0 | 1.0 | 1.0 | 1.0 | 1.0 |
| | | E-2 | | 1.0 | 1.0 | 1.0 | 1.0 | 1.0 |
| Physical property | Cured product | Relative permittivity; 1 MHz | | 2.91 | 2.89 | 2.89 | 2.96 | 2.98 |
| | | Relative permittivity; 10 GHz | | 2.76 | 2.71 | 2.77 | 2.80 | 2.83 |
| Evaluation | Metal adhesiveness | | | 3 | 4 | 4 | 4 | 4 |
| | Heat resistance | | | 3 | 4 | 4 | 3 | 4 |
| Remarks | | | | Present Invention | Present Invention | Present Invention | Present Invention | Present Invention |

**Table III Continued**

| Curable composition No. | | | | AB-1 | AB-2 | AB-3 | AB-4 | AB-5 | AB-6 |
|---|---|---|---|---|---|---|---|---|---|
| | Component | Type | No. | | | | | | |
| | (Meth)acrylic monomer | (A1) | A-3 | 54.0 | 54.0 | 54.0 | 54.0 | 54.0 | 54.0 |
| | | | A-8 | 34.0 | 34.0 | 34.0 | 34.0 | 34.0 | 39.0 |
| | | (A2) | A-5 | 1.5 | 1.5 | 1.5 | 1.5 | 1.5 | 1.5 |
| | | Total | | 89.5 | 89.5 | 89.5 | 89.5 | 89.5 | 94.5 |
| | | B-1 | | 5.0 | | | | | |
| | | B-2 | | | | | | | |
| | | B-3 | | | | | | | |
| | | B-4 | | | 5.0 | | | | |
| | | B-5 | | | | | | | |
| Composition (parts by mass) | | B-6 | | | | | | | |
| | Thermosetting compound | B-7 | | | | 5.0 | | | |
| | | B-8 | | | | | | | |
| | | B-9 | | | | | 3.0 | | |
| | | B-10 | | | | | | | |
| | | B-11 | | | | | | 5.0 | |
| | | B-12 | | | | | | | |
| | Photopolymerization initiator | C-1 | | 2.5 | 2.5 | 2.5 | 2.5 | 2.5 | 2.5 |
| | | C-2 | | 0.5 | 0.5 | 0.5 | 0.5 | 0.5 | 0.5 |
| | Gelling agent | D-1 | | | | | | | 2.0 |
| | Pigment dispersion (amount including A-5) | E-1 | | 1.0 | 1.0 | 1.0 | 1.0 | 1.0 | 1.0 |
| | | E-2 | | 1.0 | 1.0 | 1.0 | 1.0 | 1.0 | 1.0 |
| Physical property | Cured product | Relative permittivity; 1 MHz | | 3.11 | 3.01 | 3.07 | 3.12 | 3.11 | 2.98 |
| | | Relative permittivity; 10 GHz | | 3.01 | 2.96 | 2.97 | 3.02 | 3.03 | 2.82 |
| Evaluation | Metal adhesiveness | | | 4 | 4 | 4 | 4 | 4 | 2 |
| | Heat resistance | | | 4 | 4 | 4 | 4 | 4 | 1 |
| Remarks | | | | Comparative Example | Comparative Example | Comparative Example | Comparative Example | Comparative Example | Comparative Example |

**Table IV**

| Curable composition No. | | | | BB-1 | BB-2 | BB-3 | BB-4 | BB-5 |
|---|---|---|---|---|---|---|---|---|
| | Component | Type | No. | | | | | |
| | | (A1) | A-4 | 40 | 10 | 35 | 20 | 10 |
| | | | A-6 | 20 | 20 | | | 20 |
| | | | A-8 | | 20 | 36 | 18 | 20 |
| | | | A-3 | 28 | 28 | | 30 | 31 |
| | (Meth)acrylic monomer | | A-9 | | 10 | | 10 | 10 |
| | | (A2) | A-2 | | | 8 | | |
| | | | A-5 | 1.5 | 1.5 | 1.5 | 11.5 | 1.5 |
| | | | A-7 | | | 9 | | |
| Composition (parts by mass) | | Other | A-1 | | | | | |
| | | Total | | 89.5 | 89.5 | 89.5 | 89.5 | 92.5 |
| | Thermosetting compound | B-4 | | 5 | 5 | 5 | 5 | 3 |
| | Photopolymerization initiator | C-1 | | 2.5 | 2.5 | 2.5 | 2.5 | 2.5 |
| | | C-2 | | 0.5 | 0.5 | 0.5 | 0.5 | 0.5 |
| | Gelling agent | D-1 | | 1.0 | 1.0 | 1.0 | 1.0 | 1.0 |
| | | D-2 | | 1.0 | 1.0 | 1.0 | 1.0 | |
| | Pigment dispersion (amount including A-5) | E-1 | | 1.0 | 1.0 | 1.0 | 1.0 | 1.0 |
| | | E-2 | | 1.0 | 1.0 | 1.0 | 1.0 | 1.0 |
| Physical property | Cured product | Relative permittivity; 1 MHz | | 2.86 | 2.87 | 2.87 | 2.86 | 2.91 |
| | | Relative permittivity; 10 GHz | | 2.68 | 2.67 | 2.69 | 2.67 | 2.73 |
| Evaluation | Metal adhesiveness | | | 5 | 5 | 5 | 5 | 4 |
| | Heat resistance | | | 5 | 5 | 5 | 5 | 4 |
| Remarks | | | | Present Invention | Present Invention | Present Invention | Present Invention | Present Invention |

**Table IV Continued**

| Curable composition No. | | | | BB-6 | BB-7 | BB-8 | BB-9 | BB-10 | BB-11 |
|---|---|---|---|---|---|---|---|---|---|
| | Component | Type | No. | | | | | | |
| | | (A1) | A-4 | 20 | 30 | 15 | 22 | | |
| | | | A-6 | | | | | 20 | |
| | | | A-8 | 31 | 28 | 30 | 15 | | |
| | (Meth)acrylic monomer | | A-3 | | | 20 | | | |
| | | | A-9 | | | | 10 | 10 | |
| | | (A2) | A-2 | 10 | 10 | | | | |
| Composition (parts by mass) | | | A-5 | 19.5 | 11.5 | 9.5 | 7.5 | 31.5 | 34.5 |
| | | | A-7 | 9 | 10 | 15 | 11 | 28 | 35 |
| | | Other | A-1 | | | | 18 | | 20 |
| | | Total | | 89.5 | 89.5 | 89.5 | 89.5 | 89.5 | 89.5 |
| | Thermosetting compound | B-4 | | 5 | 5 | 5 | 5 | 5 | 5 |
| | Photopolymerization initiator | C-1 | | 2.5 | 2.5 | 2.5 | 2.5 | 2.5 | 2.5 |
| | | C-2 | | 0.5 | 0.5 | 0.5 | 0.5 | 0.5 | 0.5 |
| | Gelling agent | D-1 | | 1.0 | 1.0 | 1.0 | 1.0 | 1.0 | 1.0 |
| | | D-2 | | 1.0 | 1.0 | 1.0 | 1.0 | 1.0 | 1.0 |
| | Pigment dispersion (amount including A-5) | E-1 | | 1.0 | 1.0 | 1.0 | 1.0 | 1.0 | 1.0 |
| | | E-2 | | 1.0 | 1.0 | 1.0 | 1.0 | 1.0 | 1.0 |
| Physical property | Cured product | Relative permittivity; 1 MHz | | 2.92 | 2.91 | 2.92 | 2.94 | 2.94 | 2.95 |
| | | Relative permittivity; 10 GHz | | 2.74 | 2.74 | 2.75 | 2.79 | 2.80 | 2.81 |
| Evaluation | Metal adhesiveness | | | 5 | 5 | 5 | 5 | 5 | 5 |
| | Heat resistance | | | 5 | 5 | 5 | 5 | 5 | 5 |
| Remarks | | | | Present Invention | Present Invention | Present Invention | | | |

| | | | | | | | | | |
|---|---|---|---|---|---|---|---|---|---|
| BB-9, BB-10 and BB-11 are reference examples not according to the invention. | | | | | | | | | |

As shown in the above results, the curable composition of the present invention is superior to the curable compositions of Comparative Examples in terms of relative permittivity, substrate adhesiveness, and solder heat resistance. In addition, the following heat and moisture resistance, solvent resistance, acid resistance, alkali resistance, and insulation reliability were also evaluated, and it was confirmed that there were no problems in practical use.

In addition, the reproducibility of fine lines was evaluated by the following method using a comb-shaped pattern with a line and space of 100 µm, and the results showed that the sample of the present invention was able to draw a line and space of 100 µm. However, the sample of the Comparative Example not containing a gelling agent was unable to draw lines and spaces of 100 µm, and the spaces were filled with ink, or the lines were thicker than 100 µm.

### <Heat and moisture resistance>

The laminated sample with the above solid pattern was left for 500 hours at 85 °C and 85% relative humidity. Subsequently, the substrate adhesiveness was evaluated as described above, and the peeling state of the cured film was observed.

### <Solvent resistance>

After immersing the laminated sample with the above solid pattern in propylene glycol monomethyl acetate at 20 °C for 20 minutes, rinsing and drying, the substrate adhesiveness was evaluated as described above, and the peeling state of the cured film was observed. The state of the cured film was observed.

### <Acid resistance>

The laminated sample with the above solid pattern was immersed in a 10 mass% sulfuric acid solution at 20 °C for 20 minutes. After rinsing and drying, the sample was subjected to the substrate adhesiveness evaluation described above, and the peeling state of the cured film was observed.

### <Alkali resistance>

The laminated sample with the above solid pattern was immersed in a 10 mass% sodium hydroxide solution at 20 °C for 20 minutes, and then after rinsing and drying, the substrate adhesiveness was evaluated as described above, and the peeling state of the cured film was observed.

### <Insulation reliability>

A conductive comb-shaped wiring pattern having a line and space of 75 µm was formed on a copper-clad laminate (FR-4; 1.6 mm thick, 150 mm x 95 mm in size) for a printed wiring board, and a solid pattern was formed by inkjet using each inkjet ink prepared so as to cover the entire comb-shaped wiring pattern. The obtained sample was subjected to insulation evaluation under the conditions of 85 °C, 85 %RH, and application of 100 V for up to 1000 hours.

### (Criteria)

Double circle: After 1000 hours, no significant decrease in resistance value or short circuit is observed, and the insulation resistance value is 10⁸ Ω or higher.

Circle: After 500 hours, no significant decrease in resistance value or short circuit is observed, and the insulation resistance value is 10⁸ Ω or higher.

Triangle: After 250 hours, no significant decrease in resistance value or short circuit is observed, and the insulation resistance value is 10⁸ Ω or higher.

Cross mark: Insulation resistance value is less than 10⁸ Ω before 250 hours.

### <Reproducibility of fine lines>

A comb-shaped pattern with a line and space of 100 µm was observed under an optical microscope.

### [Evaluation 2]

Using the ink BB-4 obtained above, differences in adhesiveness, heat resistance, and bleeding due to difference in pretreatment of the copper layer of the copper-clad laminate were evaluated.

### (1) Preparation of laminated sample for evaluation

### <Treatment of copper-clad laminate>

The copper layer on the surface of a copper-clad laminate (FR-4; thickness 1.6 mm, 150 mm x 95 mm in size) for a printed wiring board was treated with treatment solutions of CZ-8100, CZ8101, and CZ8201 manufactured by MEC Co., Ltd. Copper clad laminates CC-2 to CC-11 having a different surface roughness Ra of the copper layer were produced by adjusting the conditions. Also, a copper-clad laminate that was not treated was used as CC-1.

### <Pattern formation by inkjet>

Using ink BB-4, a cured film pattern (70 mm x 70 mm, 23 µm thick solid pattern) was formed on the copper layers of the copper clad laminates CC-1 to CC-11 in the same manner as in Evaluation 1 above. Thus, laminated samples were obtained.

### (2) Evaluation of laminated sample

With respect to the laminated sample with the solid pattern, substrate adhesiveness and solder heat resistance were evaluated in the same manner as in Evaluation 1. In addition, bleeding was evaluated by the following method.

### <Evaluation of bleeding>

The distance of bleeding from the solid image printing (cured film pattern) portion of 70 mm x 70 mm onto the copper plate as the non-printing portion was visually confirmed and evaluated according to the following criteria.

### (Criteria)

5: Bleeding component is less than 1 mm
4: Bleeding component is 1 mm or more and less than 2 mm.
3: Bleeding component is 2 mm or more and less than 3 mm.
2: Bleeding component is 3 mm or more and less than 4 mm.
1: Bleeding component is 4 mm or more.

**Table V**

| Copper-clad laminate No. | | CC-1 | CC-2 | CC-3 | CC-4 | CC-5 | CC-6 | CC-7 | CC-8 | CC-9 | CC-10 | CC-11 |
|---|---|---|---|---|---|---|---|---|---|---|---|---|
| Copper-clad surface property | Surface roughness Ra (*µ* m) | - | 0.1 | 0.2 | 0.3 | 0.4 | 0.75 | 1.1 | 1.2 | 1.4 | 1.5 | 2.0 |
| Curable composition No. | | BB-4 | BB-4 | BB-4 | BB-4 | BB-4 | BB-4 | BB-4 | BB-4 | BB-4 | BB-4 | BB-4 |
| Evaluation | Metal adhesiveness | 2 | 3 | 3 | 4 | 5 | 5 | 5 | 5 | 5 | 5 | 5 |
| | Heat resistance | 2 | 3 | 3 | 4 | 5 | 5 | 5 | 5 | 5 | 5 | 4 |
| | Bleeding | 5 | 5 | 5 | 5 | 5 | 5 | 5 | 4 | 4 | 4 | 3 |
| Remarks | | Present Invention | Present Invention | Present Invention | Present Invention | Present Invention | Present Invention | Present Invention | Present Invention | Present Invention | Present Invention | Present Invention |

Other pretreatment agents described in the specification, GB1000F/1400, G200, GB3100, and GB4300, manufactured by Shikoku Chemicals Corporation; Multibond 100, Multibond 150, Multibond MP, and MultiPrep200, manufactured by MacDermid Inc.; and BTH-2066 and BTH-2085, manufactured by BOARDTEC Co., Ltd. were used to prepare substrates having Ra of 0.1 to 2.0 µm by adjusting treatment conditions, and the same evaluation was performed. The evaluation results corresponded to Ra described in Table V above were obtained.

Further, it was confirmed that even when the GT process of MEC Co., Ltd. or the process in GliCAP of Shikoku Chemicals Corporation, which is a pretreatment for improving adhesiveness, was used, there was no problem in evaluation of substrate adhesiveness, solder heat resistance, heat and moisture resistance, resistance to solvents, acid resistance, alkali resistance, insulating reliability and bleeding in practical use.

### Industrial Applicability

According to the present invention, it is possible to provide a curable composition that gives a cured product with excellent adhesiveness and heat resistance and low relative permittivity, a solder resist ink, and a printed circuit board using this curable composition.

## Claims

1. A curable composition comprising a (meth)acrylic monomer as a main component and further containing a photoinitiator, a thermosetting compound, and a gelling agent, wherein a cured product of the curable composition has a relative permittivity of less than 2.90 at 10 GHz, wherein
the (meth)acrylic monomer includes a (meth)acrylic monomer (A1) having a molecular weight in the range of 200 to 1,500 and a ClogP value in the range of 3.5 to 7.0,
the (meth)acrylate (A1) is contained in the range of 50 to 95% by mass with respect to the entire curable composition,
the thermosetting compound has a thermosetting functional group selected from the group consisting of an isocyanate group, an epoxy group, a maleimide group, and an isocyanate group which is protected by a thermally dissociable blocking agent,
the gelling agent is selected from the group consisting of ketone waxes, ester waxes, higher fatty acids, higher alcohols, and fatty acid amides, and
the relative permittivity at 10 GHz and the ClogP value are determined by the methods described in the description.

2. The curable composition according to claim 1, wherein a content of the thermosetting compound is in the range of 1 to 15% by mass based on the total amount of the curable composition.

3. The curable composition according to claim 1 or 2, wherein the thermosetting compound includes a polyfunctional isocyanate compound in which an isocyanate group is protected by a thermally dissociative blocking agent.

4. The curable composition according to any one of claims 1 to 3, having a viscosity at 25 °C in the range of 1 to 1 x 10⁴ Pa·s, and a phase transition point in the range of 40 °C or higher and less than 100 °C, wherein the viscosity is measured at a shear rate of 1000 (1/s) using a viscoelasticity measuring device, and the phase transition point is a temperature at which the complex viscosity becomes 1 Pa in a viscoelastic curve obtained by changing the temperature at a cooling rate of 0.1 °C/s, a strain of 5%, an angular frequency of 10 radian/s, and a cooling rate of 0.1 °C/s.

5. A solder resist ink comprising the curable composition according to any one of claims 1 to 4.

6. A printed circuit board comprising: a substrate; a circuit pattern provided on a surface of the substrate; and a solder resist film provided on the circuit pattern, wherein the solder resist film is formed by using the solder resist ink according to claim 5.

7. The printed circuit board according to claim 6, wherein the circuit pattern is composed of a copper wiring, and a surface roughness Ra of the copper wiring is in the range of 0.1 to 2.0 µm, wherein the surface roughness Ra is an arithmetic average roughness measured based on JIS B 0601 as described in the description.

## Patentansprüche

1. Härtbare Zusammensetzung, umfassend ein (Meth)acrylmonomer als eine Hauptkomponente und ferner enthaltend einen Photopolymerisationsinitiator, eine wärmehärtende Verbindung und ein Geliermittel, wobei ein gehärtetes Produkt der härtbaren Zusammensetzung eine relative Permittivität von weniger als 2,90 bei 10 GHZ aufweist, wobei
das (Meth)acrylmonomer ein (Meth)acrylmonomer (A1) mit einem Molekulargewicht im Bereich von 200 bis 1.500 und einem ClogP-Wert im Bereich von 3,5 bis 7,0 einschließt,
das (Meth)acrylat (A1) im Bereich von 50 bis 95 Masse-% in Bezug auf die gesamte härtbare Zusammensetzung enthalten ist,
die wärmehärtende Verbindung eine wärmehärtende funktionelle Gruppe aufweist, die aus der Gruppe, bestehend aus einer Isocyanatgruppe, einer Epoxygruppe, einer Maleimidgruppe und einer Isocyanatgruppe, die durch ein thermisch dissoziierbares Blockierungsmittel geschützt ist, ausgewählt ist,
das Geliermittel aus der Gruppe, bestehend aus Ketonwachsen, Esterwachsen, höheren Fettsäuren, höheren Alkoholen und Fettsäureamiden, ausgewählt ist und
die relative Permittivität bei 10 GHz und der ClogP-Wert durch die in der Beschreibung beschriebenen Verfahren bestimmt werden.

2. Härtbare Zusammensetzung gemäß Anspruch 1, wobei ein Gehalt der wärmehärtenden Verbindung im Bereich von 1 bis 15 Masse-%, bezogen auf die Gesamtmenge der härtbaren Zusammensetzung, liegt.

3. Härtbare Zusammensetzung gemäß Anspruch 1 oder 2, wobei die wärmehärtende Verbindung eine polyfunktionelle Isocyanatverbindung einschließt, in der eine Isocyanatgruppe durch eine thermisch dissoziatives Blockierungsmittel geschützt ist.

4. Härtbare Zusammensetzung gemäß einem der Ansprüche 1 bis 3, die eine Viskosität bei 25°C im Bereich von 1 bis 1 × 10⁴ Pa·s und einen Phasenübergangspunkt im Bereich von 40°C oder höher und weniger als 100°C aufweist, wobei die Viskosität bei einer Schergeschwindigkeit von 1.000 (1/s) unter Verwendung einer Viskoelastizitätsmessvorrichtung gemessen wird und der Phasenübergangspunkt eine Temperatur ist, bei der die komplexe Viskosität 1 Pa in einer Viskoelastizitätskurve beträgt, die durch Änderung der Temperatur bei einer Abkühlungsgeschwindigkeit von 0,1°C/s, einer Dehnung von 5 %, einer Kreisfrequenz von 10 Radiant/s und einer Abkühlungsgeschwindigkeit von 0,1°C/s erhalten wird.

5. Lötstopplacktinte, umfassend die härtbare Zusammensetzung gemäß einem der Ansprüche 1 bis 4.

6. Leiterplatte, umfassend ein Substrat, ein Schaltungsmuster, das auf einer Oberfläche des Substrats angeordnet ist, und einen Lötstopplackfilm, der auf dem Schaltungsmuster angeordnet ist, wobei der Lötstopplackfilm unter Verwendung der Lötstopplacktinte gemäß Anspruch 5 gebildet ist.

7. Leiterplatte gemäß Anspruch 6, wobei das Schaltungsmuster aus einer Kupferverdrahtung zusammengesetzt ist und eine Oberflächenrauheit Ra der Kupferverdrahtung im Bereich von 0,1 bis 2,0 µm liegt, wobei die Oberflächenrauheit Ra ein arithmetischer Mittenrauhwert, gemessen auf Basis von JIS B 0601 wie in der Beschreibung beschrieben, ist.

## Revendications

1. Composition durcissable comprenant un monomère (méth)acrylique en tant que composant principal et contenant en outre un photoinitiateur, un composé thermodurcissable et un agent gélifiant, dans laquelle un produit durci de la composition durcissable présente une permittivité relative inférieure à 2,90 à 10 GHz, dans laquelle
le monomère (méth)acrylique inclut un monomère (méth)acrylique (A1) présentant une masse moléculaire dans la plage de 200 à 1 500 et une valeur de ClogP dans la plage de 3,5 à 7,0,
le (méth)acrylate (A1) est contenu dans la plage de 50 à 95 % en masse par rapport à la totalité de la composition durcissable,
le composé thermodurcissable présente un groupe fonctionnel thermodurcissable sélectionné dans le groupe consistant en un groupe isocyanate, un groupe époxy, un groupe maléimide et un groupe isocyanate qui est protégé par un agent de blocage thermodissociable,
l'agent gélifiant est sélectionné dans le groupe consistant en des cires cétoniques, des cires estériques, des acides gras supérieurs, des alcools supérieurs et des amides d'acides gras, et
la permittivité relative à 10 GHz et la valeur de ClogP sont déterminées par les procédés décrits dans la description.

2. Composition durcissable selon la revendication 1, dans laquelle une teneur en composé thermodurcissable est dans la plage de 1 à 15 % en masse sur la base de la quantité totale de la composition durcissable.

3. Composition durcissable selon la revendication 1 ou la revendication 2, dans laquelle le composé thermodurcissable inclut un composé isocyanate polyfonctionnel dans lequel un groupe isocyanate est protégé par un agent de blocage thermodissociable.

4. Composition durcissable selon l'une quelconque des revendications 1 à 3, présentant une viscosité à 25 °C dans la plage de 1 à 1 × 10⁴ Pa·s et un point de transition de phase dans la plage de 40 °C ou supérieur et inférieur à 100 °C, dans laquelle la viscosité est mesurée à une vitesse de cisaillement de 1 000 (1/s) en utilisant un dispositif de mesure de viscoélasticité et le point de transition de phase est une température à laquelle la viscosité complexe devient 1 Pa dans une courbe viscoélastique obtenue en changeant la température à une vitesse de refroidissement de 0,1 °C/s, une déformation de 5 %, une pulsation de 10 radian/s et une vitesse de refroidissement de 0,1 °C/s.

5. Encre pour réserve de soudure comprenant la composition durcissable selon l'une quelconque des revendications 1 à 4.

6. Carte de circuit imprimé comprenant : un substrat ; un motif de circuit disposé sur une surface du substrat ; et un film de réserve de soudure disposé sur le motif de circuit, dans laquelle le film de réserve de soudure est formé en utilisant l'encre pour réserve de soudure selon la revendication 5.

7. Carte de circuit imprimé selon la revendication 6, dans laquelle le motif de circuit est composé d'un câblage en cuivre et une rugosité de surface Ra du câblage en cuivre est dans la plage de 0,1 à 2,0 µm, dans laquelle la rugosité de surface Ra est une rugosité moyenne arithmétique mesurée sur la base de la norme JIS B 0601 comme décrit dans la description.
